# EUROPEAN PATENT APPLICATION

(11) **EP 4 746 633 A1**
(43) Date of publication of application: **20.05.2026**
(21) Application number: 25192075.7
(22) Date of filing: 28.07.2025
(51) Int. Cl.: H10D 64/01, H10D 64/23, H10D 84/83, H10D 88/00, H10P 14/40, H10W 20/42, H10W 20/40, H10D 30/01, H10D 62/822, H10D 62/13, H10D 30/69, B82Y 10/00, H10W 20/41

(54) **SEMICONDUCTOR DEVICE**

(30) Priority: 18.11.2024 KR 20240164430
(71) Applicant: SAMSUNG ELECTRONICS CO., LTD., Yeongtong-gu Suwon-si, Gyeonggi-do 16677 (KR)
(72) Inventor: SON, Soo Min, 16677 Suwon-si, Gyeonggi-do (KR); YANG, Suk, 16677 Suwon-si, Gyeonggi-do (KR); LEE, Sang Moon, 16677 Suwon-si, Gyeonggi-do (KR); HAN, Soo Bin, 16677 Suwon-si, Gyeonggi-do (KR); XU, Yang, 16677 Suwon-si, Gyeonggi-do (KR)
(74) Representative: Kuhnen & Wacker Patent- und Rechtsanwaltsbüro PartG mbB

(57) **Abstract**

A semiconductor device includes a back interlayer insulating film (180); a plurality of first channel patterns (NS1) on the back interlayer insulating film (180) and spaced apart from each other in a vertical direction (DR3); a plurality of second channel patterns (NS2) on the back interlayer insulating film (180) and spaced apart from each other in the vertical direction (DR3); a source/drain pattern (160) between the first channel patterns (NS1) and the second channel patterns (NS2); and a source/drain contact (195, 295) connected to the source/drain pattern (160), wherein the source/drain pattern (160) includes a first layer (161) which comes into contact with (162) the first channel patterns (NS1) and the second channel patterns (NS2), a second layer (162) on or below the first layer (161), and a third layer (163) on or above the second layer (162), wherein a width of the first layer (161) in the vertical direction (DR3) decreases and then increases, along a direction from the first channel patterns (NS1) to the second channel patterns (NS2).

## Description

### BACKGROUND

One or more example embodiments of the present disclosure relate to a semiconductor device, and more particularly, to a semiconductor device including an MBCFET^{™} (Multi-Bridge Channel Field Effect Transistor).

As one of scaling technologies for increasing density of an integrated circuit device, a multi-gate transistor in which a silicon body of a fin or nanowire shape is formed on a substrate and a gate is formed on a surface of the silicon body has been proposed.

Since such a multi-gate transistor utilizes a three-dimensional channel, scaling is easily performed. Further, even if a gate length of the multi-gate transistor is not increased, a current control capability may be improved. Furthermore, a SCE (short channel effect) in which potential of a channel region is influenced by a drain voltage may be effectively suppressed. However, there is a need for a technology to reduce a contact resistance between a source/drain contact and a source/drain pattern.

### SUMMARY

One or more example embodiments of the present disclosure provide a semiconductor device in which a contact resistance between a source/drain contact and a source/drain pattern decreases.

According to an aspect of an example embodiment of the disclosure, there is provided a semiconductor device including: a back interlayer insulating film; a plurality of first channel patterns on the back interlayer insulating film and spaced apart from each other in a vertical direction; a plurality of second channel patterns on the back interlayer insulating film, spaced apart from each other in the vertical direction, and spaced apart from the plurality of first channel patterns in a first horizontal direction; a source/drain pattern between the plurality of first channel patterns and the plurality of second channel patterns; and a source/drain contact connected to the source/drain pattern, wherein the source/drain pattern includes a first layer which comes into contact with the plurality of first channel patterns and the plurality of second channel patterns, a second layer on or below the first layer, and a third layer on or above the second layer, wherein a width of the first layer in the vertical direction decreases and then increases, along a direction from the plurality of first channel patterns to the plurality of second channel patterns.

According to an aspect of an example embodiment of the disclosure, there is provided a semiconductor device including: a back interlayer insulating film; a plurality of first channel patterns on the back interlayer insulating film and spaced apart from each other in a vertical direction; a plurality of second channel patterns on the back interlayer insulating film, spaced apart from each other in the vertical direction, and spaced apart from the plurality of first channel patterns in a first horizontal direction; a source/drain pattern between the plurality of first channel patterns and the plurality of second channel patterns; and a source/drain contact connected to the source/drain pattern, wherein the source/drain pattern includes a first layer which comes into contact with the plurality of first channel patterns and the plurality of second channel patterns, a second layer on or below the first layer, and a third layer on or above the first layer, and including a same material as the second layer.

According to an aspect of an example embodiment of the disclosure, there is provided a semiconductor device including: a first lower channel pattern and a second lower channel pattern which are spaced apart from each other in a first horizontal direction; a first upper channel pattern spaced apart from the first lower channel pattern in a vertical direction; a second upper channel pattern spaced apart from the second lower channel pattern in the vertical direction; a lower source/drain pattern which comes into contact with the first lower channel pattern and the second lower channel pattern; and an upper source/drain pattern which comes into contact with the first upper channel pattern and the second upper channel pattern, wherein the lower source/drain pattern includes a first lower layer which comes into contact with the first lower channel pattern and the second lower channel pattern, a second lower layer on or below the first lower layer, and a third lower layer on or above the first lower layer, and the upper source/drain pattern includes a first upper layer which comes into contact with the first upper channel pattern and the second upper channel pattern, a second upper layer on or below the first upper layer, and a third upper layer on or above the first upper layer.

However, aspects of the present disclosure are not restricted to the one set forth herein. The above and other aspects of the present disclosure will become more apparent to one of ordinary skill in the art to which the present disclosure pertains by referencing the detailed description of the present disclosure given below.

### BRIEF DESCRIPTION OF DRAWINGS

The above and other aspects and features of the present disclosure will become more apparent by describing in detail example embodiments thereof with reference to the attached drawings, in which:
FIG. 1 is an example layout diagram for explaining a semiconductor device according to one or more embodiments;
FIGS. 2 and 5 are example cross-sectional views taken along A-A' of FIG. 1;
FIG. 3 is an example cross-sectional view taken along B-B' of FIG. 1;
FIG. 4 is an example cross-sectional view taken along C-C' of FIG. 1;
FIGS. 6 to 18 are diagrams for explaining a semiconductor device according to one or more embodiments; and
FIGS. 19 to 43 are intermediate stage diagrams for explaining a method for fabricating a semiconductor device according to one or more embodiments.

### DETAILED DESCRIPTION

Hereinafter, example embodiments are described in detail with reference to the accompanying drawings. Like reference numerals are used for like components in the drawings, and redundant descriptions thereof are omitted.

It will be understood that, although the terms first, second, third, fourth, etc. may be used herein to describe various elements, components, regions, layers and/or sections (collectively "elements"), these elements should not be limited by these terms. These terms are only used to distinguish one element from another element. Thus, a first element described in this description section may be termed a second element or vice versa in the claim section without departing from the teachings of the disclosure.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

As used herein, an expression "at least one of" preceding a list of elements modifies the entire list of the elements and does not modify the individual elements of the list. For example, an expression, "at least one of a, b, and c" should be understood as including only a, only b, only c, both a and b, both a and c, both b and c, or all of a, b, and c.

Herein, a direction on a plane defined by an X-axis and a Y-axis may be referred to as a horizontal direction, and a direction along a Z-axis direction may be referred to as a vertical direction. A component positioned in a +Z-axis direction relative to other components may be referred to as being above other components, and a component positioned in a -Z-axis direction relative to other components may be referred to as being below other components.

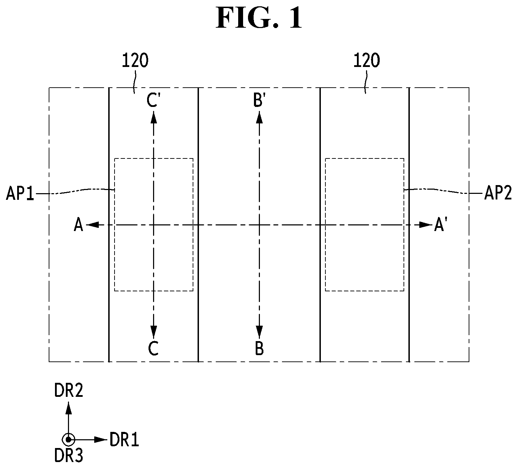

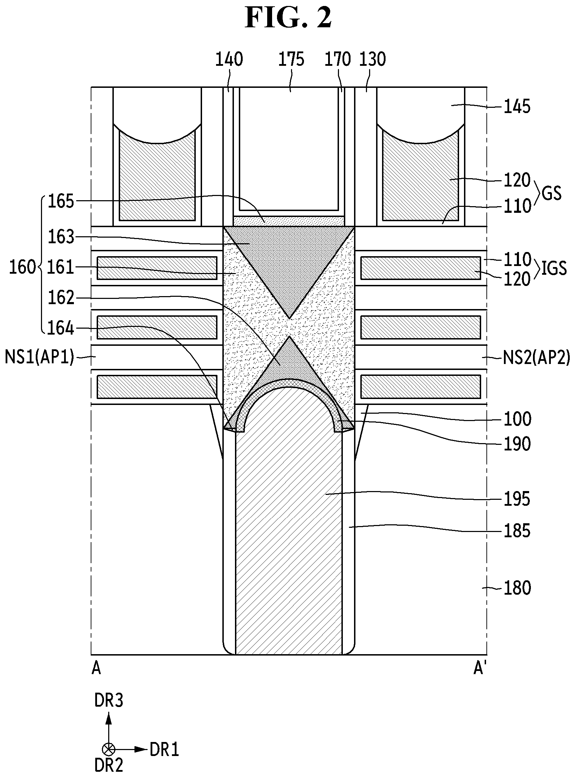

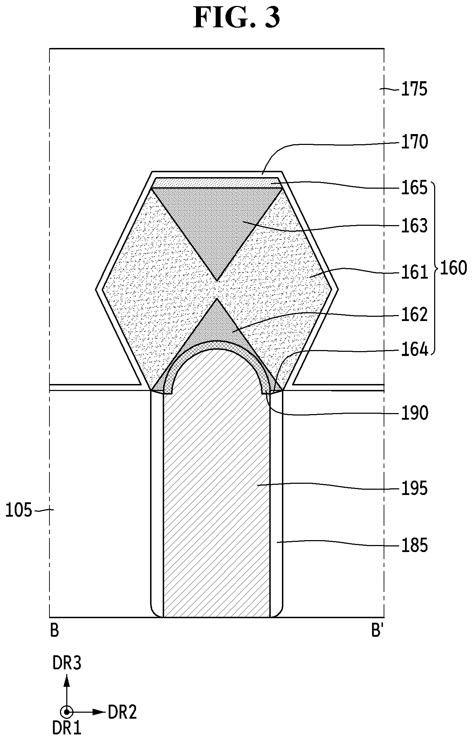

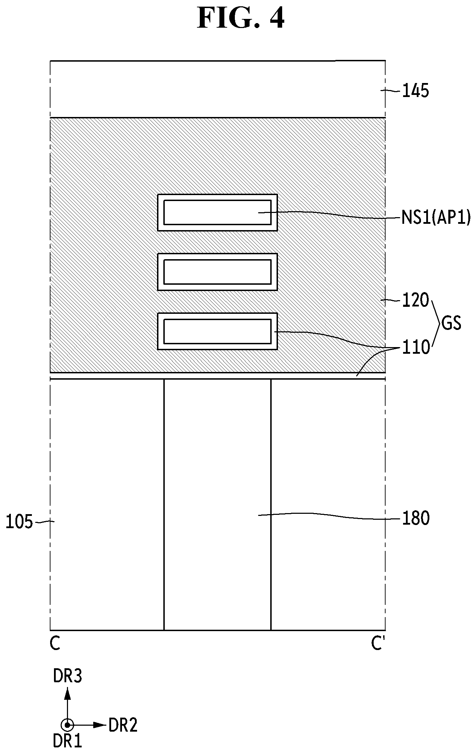

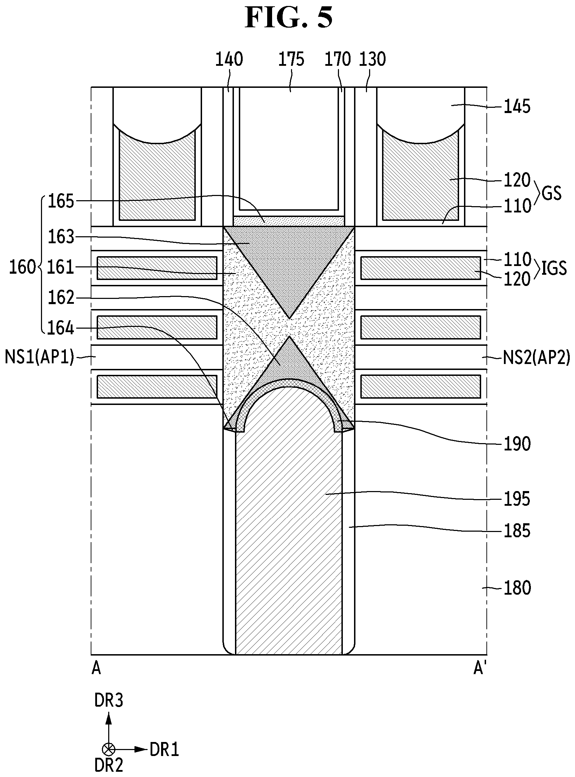

FIG. 1 is an example layout diagram for explaining a semiconductor device according to one or more embodiments. FIGS. 2 and 5 are example cross-sectional views taken along A-A' of FIG. 1. FIG. 3 is an example cross-sectional view taken along B-B' of FIG. 1. FIG. 4 is an example cross-sectional view taken along C-C' of FIG. 1.

Referring to FIGS. 1 to 5, the semiconductor device according to one or more embodiments may include a first active pattern AP1, a second active pattern AP2, a plurality of gate electrodes 120, a source/drain pattern 160, a back source/drain contact 195, and a back interlayer insulating film 180.

The back interlayer insulating film 180 may include at least one of, for example, a silicon oxide, a silicon nitride, a silicon carbonitride, a silicon oxynitride, and a low dielectric constant material. A dielectric constant of the low dielectric constant material may have a value smaller than 3.9, which is a dielectric constant of the silicon oxide. Although the back interlayer insulating film 180 is shown as being a single film, this is only for convenience of explanation, and the embodiment is not limited thereto.

The back interlayer insulating film 180 may extend in a first horizontal direction DR1. The back interlayer insulating film 180 may include an upper surface and a bottom surface that are opposite to each other in a vertical direction DR3.

A field insulating film 105 may be disposed on a side wall of the back interlayer insulating film 180. The field insulating film 105 may cover the side wall of the back interlayer insulating film 180. The field insulating film 105 may include at least one of, for example, a silicon oxide, a silicon nitride, a silicon oxynitride, and a low dielectric constant material. Although the field insulating film 105 is shown as being a single film, this is only for convenience of explanation, and the embodiment is not limited thereto.

When the back interlayer insulating film 180 and the field insulating film 105 are each a single film and include the same insulating material, a boundary between the back interlayer insulating film 180 and the field insulating film 105 may not be distinguished.

The first active pattern AP1 and the second active pattern AP2 may be disposed on an upper surface of the back interlayer insulating film 180. The first active pattern AP 1 and the second active pattern AP2 may be spaced apart from each other in the first horizontal direction DR1. The first active pattern AP1 and the second active pattern AP2 may be adjacent to each other in the first horizontal direction DR1.

Each of the first active pattern AP1 and the second active pattern AP2 may be a multi-channel active pattern. In some embodiments, the first active pattern AP1 may include a plurality of first channel patterns NS1, and the second active pattern AP2 may include a plurality of second channel patterns NS2. In some embodiments, each of the first and second active patterns AP1 and AP2 may be an active pattern including a nanosheet or a nanowire.

The plurality of first channel patterns NS1 may be disposed on the upper surface of the back interlayer insulating film 180. The plurality of first channel patterns NS1 may be spaced apart from each other in the vertical direction DR3.

The plurality of second channel patterns NS2 may be disposed on the upper surface of the back interlayer insulating film 180. The plurality of second channel patterns NS2 may be spaced apart from the plurality of first channel patterns NS1 in the first horizontal direction DR1 on the upper surface of the back interlayer insulating film 180. The plurality of second channel patterns NS2 may be adjacent to the plurality of first channel patterns NS1 in the first horizontal direction DR1. The plurality of second channel patterns NS2 may be spaced apart from each other in the vertical direction DR3.

Although three first channel patterns NS1 and three second channel patterns NS2 are shown as being disposed in the vertical direction DR3, this is only for convenience of explanation, and the embodiment is not limited thereto.

The first channel patterns NS1 and the second channel patterns NS2 may each include, for example, but not limited to, silicon or germanium, which is an elemental semiconductor material. Also, the first channel patterns NS1 and the second channel patterns NS2 may each include a compound semiconductor, and may include, for example, a group IV-IV compound semiconductor or a group III-V compound semiconductor.

The group IV-IV compound semiconductor may be, for example, but not limited to, a binary compound or a ternary compound including at least two of carbon (C), silicon (Si), germanium (Ge), and tin (Sn), or a compound obtained by doping any of these elements with a group IV element.

The group III-V compound semiconductor may be, for example, but not limited to, one of binary compounds, ternary compounds or quaternary compounds formed by combining at least one of aluminum (Al), gallium (Ga), and indium (In), which are group III elements, with one of phosphorus (P), arsenic (As), and antimonium (Sb), which are group V elements.

Widths of the first channel patterns NS1 are shown as being the same, but the embodiment is not limited thereto. A width of each first channel pattern NS1 may increase or decrease in proportion to a width of the back interlayer insulating film 180 in a second direction DR2. Descriptions of widths of the second channel patterns NS2 may be substantially the same as descriptions of the widths of the first channel patterns NS1.

A plurality of gate structures GS may be disposed on the field insulating film 105 and the back interlayer insulating film 180. The plurality of gate structures GS may be disposed on the upper surface of the back interlayer insulating film 180.

Each gate structure GS may extend in the second horizontal direction DR2. The gate structures GS may be disposed to be spaced apart from each other in the first horizontal direction DR1. The gate structures GS may be adjacent to each other in the first horizontal direction DR1. The gate structures GS may intersect the back interlayer insulating film 180.

The gate structures GS may surround the respective first channel patterns NS1. The gate structures GS may surround the respective second channel patterns NS2.

The gate structures GS may include, for example, a gate insulating film 110 and a gate electrode 120.

The gate structures GS may include a plurality of inner gate structures IGS which are disposed between the first channel patterns NS1 adjacent in the vertical direction DR3, between the back interlayer insulating film 180 and the first channel pattern NS1 adjacent to each other in the vertical direction DR3, between the second channel patterns NS2 adjacent to each other in the vertical direction DR3, and between the back interlayer insulating film 180 and the second channel pattern NS2 adjacent to each other in the vertical direction DR3. The inner gate structures IGS may include the gate insulating film 110 and the gate electrode 120.

The inner gate structure IGS may come into contact with an upper surface of one of the first channel patterns NS1 and a bottom surface of one of the first channel patterns NS1. The inner gate structure IGS may come into contact with an upper surface of one of the second channel patterns NS2 and a bottom surface of one of the second channel patterns NS2.

A bottom surface of one of the inner gate structures IGS may come into contact with the upper surface of the back interlayer insulating film 180. A side surface of the inner gate structure IGS may come into contact with the source/drain pattern 160.

The gate electrode 120 may be disposed on the back interlayer insulating film 180. The gate electrode 120 may intersect the back interlayer insulating film 180. The gate electrode 120 may surround the first channel pattern NS1 and the second channel pattern NS2.

An upper surface of the gate electrode 120 is shown as being a concave curved surface, but is not limited thereto. It is to be understood that the upper surface of the gate electrode 120 may have any other form, e.g., a flat surface.

The gate electrode 120 may include at least one of a metal, a conductive metal nitride, a metal silicide, a doped semiconductor material, a conductive metal oxide, and a conductive metal oxynitride. The gate electrode 120 may include, for example, but not limited to, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlCN), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (NiPt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and any combination thereof. The conductive metal oxide and the conductive metal oxynitride may include, but not limited to, an oxidized form of the aforementioned materials.

The gate insulating film 110 may extend along an upper surface of the field insulating film 105 and the upper surface of the back interlayer insulating film 180. The gate insulating film 110 may surround the plurality of first channel patterns NS1. The gate insulating film 110 may surround the plurality of second channel patterns NS2. The gate insulating film 110 may be disposed along a periphery of the first channel pattern NS1 and a periphery of the second channel pattern NS2. The gate electrode 120 may be disposed on the gate insulating film 110.

The gate insulating film 110 may be disposed between the gate electrode 120 and the first channel pattern NS1, and between the gate electrode 120 and the second channel pattern NS2. For example, the gate insulating film 110 may come into contact with the back interlayer insulating film 180. The gate insulating film 110 included in the inner gate structure IGS may come into contact with the source/drain pattern 160.

The gate insulating film 110 may include silicon oxide, silicon oxynitride, silicon nitride or a high dielectric constant material having a dielectric constant greater than that of silicon oxide. The high dielectric constant material may include, for example, but not limited to, one or more of boron nitride, hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide or lead zinc niobate.

Although the gate insulating film 110 is shown as being a single film, this is only for convenience of explanation, and the embodiment is not limited thereto. The gate insulating film 110 may include a plurality of films. The gate insulating film 110 may also include an interfacial layer disposed between the first channel pattern NS1 and the gate electrode 120, and between the second channel pattern NS2 and the gate electrode 120, and a high dielectric constant insulating film. For example, the interfacial layer may not be formed along a profile of the upper surface of the field insulating film 105.

The semiconductor device according to some other embodiments may include an NC (Negative Capacitance) FET that uses a negative capacitor. For example, each of the gate insulating film 110 may include a ferroelectric material film having ferroelectric properties, and a paraelectric material film having paraelectric properties.

The ferroelectric material film may have a negative capacitance, and the paraelectric material film may have a positive capacitance. For example, if two or more capacitors are connected in series and a capacitance of each capacitor has a positive value, an overall capacitance may decrease from the capacitance of each of the individual capacitors. On the other hand, if at least one of the capacitances of two or more capacitors connected in series has a negative value, the overall capacitance may be greater than an absolute value of each capacitance of the individual capacitors, while having a positive value.

When the ferroelectric material film having the negative capacitance and the paraelectric material film having the positive capacitance are connected in series, a value of the overall capacitance of the ferroelectric material film and the paraelectric material film connected in series may increase. By using the increased overall capacitance value, a transistor including the ferroelectric material film may have a subthreshold swing (SS) below 60 mV/decade at room temperature.

The ferroelectric material film may have ferroelectric properties. The ferroelectric material film may include, for example, at least one of, for example, but not limited to, hafnium oxide, hafnium zirconium oxide, barium strontium titanium oxide, barium titanium oxide, and lead zirconium titanium oxide. Here, as an example, the hafnium zirconium oxide may be a material formed by doping hafnium oxide with zirconium (Zr). As another example, the hafnium zirconium oxide may be a compound of hafnium (Hf), zirconium (Zr), and oxygen (O).

The ferroelectric material film may further include a doped dopant. For example, the dopant may include at least one of aluminum (Al), titanium (Ti), niobium (Nb), lanthanum (La), yttrium (Y), magnesium (Mg), silicon (Si), calcium (CA), cerium (Ce), dysprosium (Dy), erbium (Er), gadolinium (Gd), germanium (Ge), scandium (Sc), strontium (Sr), and tin (Sn). A type of the dopant included in the ferroelectric material film may vary, depending on which type of the ferroelectric material is included in the ferroelectric material film.

When the ferroelectric material film includes hafnium oxide, the dopant included in the ferroelectric material film may include, for example, but not limited to, at least one of gadolinium (Gd), silicon (Si), zirconium (Zr), aluminum (Al), and yttrium (Y).

When the dopant is aluminum (Al), the ferroelectric material film may include 3 to 8 at% (atomic %) aluminum. Here, a ratio of the dopant may be a ratio of aluminum to a sum of hafnium and aluminum.

When the dopant is silicon (Si), the ferroelectric material film may include 2 to 10 at% silicon. When the dopant is yttrium (Y), the ferroelectric material film may include 2 to 10 at% yttrium. When the dopant is gadolinium (Gd), the ferroelectric material film may include 1 to 7 at% gadolinium. When the dopant is zirconium (Zr), the ferroelectric material film may include 50 to 80 at% zirconium.

The paraelectric material film may have the paraelectric properties. The paraelectric material film may include at least one of, for example, but not limited to, a silicon oxide and a metal oxide having a high dielectric constant. The metal oxide included in the paraelectric material film may include, for example, but not limited to, at least one of hafnium oxide, zirconium oxide, and aluminum oxide.

The ferroelectric material film and the paraelectric material film may include the same material. The ferroelectric material film has the ferroelectric properties, but the paraelectric material film may not have the ferroelectric properties. For example, when the ferroelectric material film and the paraelectric material film include hafnium oxide, a crystal structure of hafnium oxide included in the ferroelectric material film is different from a crystal structure of hafnium oxide included in the paraelectric material film.

The ferroelectric material film may have a thickness having the ferroelectric properties. A thickness of the ferroelectric material film may be, for example, but not limited to, 0.5 to 10 nm. Since a critical thickness that exhibits the ferroelectric properties may vary for each ferroelectric material, the thickness of the ferroelectric material film may vary depending on the ferroelectric material included in the ferroelectric material film.

As an example, the gate insulating film 110 may include one ferroelectric material film. As another example, the gate insulating film 110 may include a plurality of ferroelectric material films spaced apart from each other. The gate insulating film 110 may have a stacked film structure in which the plurality of ferroelectric material films and the plurality of paraelectric material films are alternately stacked.

A gate spacer 130 may be disposed on a side wall of the gate electrode 120. The gate spacer 130 may not be disposed between the back interlayer insulating film 180 and the first channel pattern NS1, and between the first channel patterns NS1 adjacent to each other in the vertical direction DR3. The gate spacer 130 may not be disposed between the back interlayer insulating film 180 and the second channel pattern NS2, and between the second channel patterns NS2 adjacent to each other in the vertical direction DR3.

The gate spacer 130 may include at least one of, for example, but not limited to, at least one of silicon nitride (SiN), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC), and any combination thereof. Although the gate spacers 130 are each shown as being a single film, this is only for convenience of explanation, and the embodiment is not limited thereto.

A gate capping pattern 145 may be disposed on the gate electrode 120. An upper surface of the gate capping pattern 145 may be disposed on the same plane as an upper surface of a front interlayer insulating film 175. Unlike the shown example, the gate capping pattern 145 may be disposed between the gate spacers 130.

The gate capping pattern 145 may include, for example, at least one of silicon nitride (SiN), silicon oxynitride (SiON), silicon carbonitride (SiCN), silicon oxycarbonitride (SiOCN), and any combination thereof. The gate capping pattern 145 may include a material having an etching selectivity with respect to the front interlayer insulating film 175.

A source/drain pattern 160 may be disposed on the back interlayer insulating film 180. The source/drain pattern 160 may be disposed on at least one side surface of the gate electrode 120. The source/drain pattern 160 may be disposed between the gate electrodes 120 adjacent to each other in the first horizontal direction DR1.

The source/drain pattern 160 may be disposed between the first channel pattern NS1 and the second channel pattern NS2. The source/drain pattern 160 may come into contact with the first channel pattern NS1 and the second channel pattern NS2. The source/drain pattern 160 may be connected to an end portion of the first channel pattern NS1 and an end portion of the second channel pattern NS2 that are opposite to each other.

Although not shown, the source/drain pattern 160 may be disposed on both sides of the first channel pattern NS1 and on both sides of the second channel pattern NS2.

Although an external shape of the source/drain pattern 160 is shown to have a shape similar to a hexagon in the drawings, the embodiment is not limited thereto. Unlike the shown example, the external shape of the source/drain pattern 160 may be a shape similar to a pentagon or a rectangle.

In some embodiments, the source/drain pattern 160 may include a first layer 161, a second layer 162, a third layer 163, a fourth layer 164, and a fifth layer 165.

The first layer 161 may come into contact with the first channel pattern NS1 and the second channel pattern NS2. The first layer 161 may come into contact with the gate insulating film 110. A thickness of the first layer 161 in the vertical direction DR3 may decrease and then increase along a direction approaching the second channel pattern NS2 from the first channel pattern NS1. A distance between the second layer 162 and the third layer 163 in the vertical direction DR3 may decrease and then increase along a direction approaching the second channel pattern NS2 from the first channel pattern NS1.

The second layer 162 may be disposed on or below the first layer 161. The third layer 163 may be disposed on or above the first layer 161. The second layer 162 and the third layer 163 may include the same material as each other.

In some embodiments, the second layer 162 and the third layer 163 may be separated from each other without coming into contact with each other. The first layer 161 may fill the gap between the second layer 162 and the third layer 163. A width of the second layer 162 in the vertical direction DR3 may increase and then decrease along a direction approaching the second channel pattern NS2 from the first channel pattern NS1. A width of the third layer 163 in the vertical direction DR3 may increase and then decrease, along a direction approaching the second channel pattern NS2 from the first channel pattern NS 1.

The fourth layer 164 may be disposed on or below the second layer 162. The fourth layer 164 may be disposed at a lowermost part of the source/drain pattern 160. The fifth layer 165 may be disposed above the third layer 163. The fifth layer 165 may be disposed at an uppermost part of the source/drain pattern 160. The fifth layer 165 may include the same material as the fourth layer 164.

In some embodiments, the source/drain pattern 160 may include the first layer 161, the second layer 162, the third layer 163, and the fifth layer 165. That is, unlike the shown example, the fourth layer 164 may be omitted.

The source/drain pattern 160 may include a semiconductor material. The source/drain pattern 160 may include, for example, but not limited to, silicon or germanium, which is an elemental semiconductor material. The source/drain pattern 160 may also include, for example, but not limited to, a binary compound or a ternary compound including at least two of carbon (C), silicon (Si), germanium (Ge) and tin (Sn), or a compound formed by doping any of these elements with a group IV element.

The source/drain pattern 160 may include a dopant doped into the semiconductor material. As an example, the first and second channel patterns NS1 and NS2 may be used as a channel region of a p-type transistor, the source/drain pattern 160 may be included in the source/drain of the p-type transistor, and the source/drain pattern 160 may include a p-type dopant. The p-type dopant may include, but not limited to, at least one of boron (B) and gallium (Ga). As another example, the first and second channel patterns NS1 and NS2 may be used as a channel region of an n-type transistor, the source/drain pattern 160 may be included in the source/drain of the n-type transistor, and the source/drain pattern 160 may include an n-type dopant. The n-type dopant may include, but not limited to, at least one of phosphorus (P), arsenic (As), antimony (Sb), and bismuth (Bi).

In some embodiments, the first layer 161 may include silicon (Si) doped with boron (B) and/or silicon carbide (SiC) doped with boron (B). The second layer 162 and the third layer 163 may include silicon germanium (SiGe) doped with boron (B), silicon germanium carbon (SiGeC) doped with boron (B), silicon (Si) doped with boron (B), and/or silicon carbide (SiC) doped with boron (B).

A concentration of the doping material doped in each of the second layer 162 and the third layer 163 may be equal to or greater than a concentration of the doping material doped in the first layer 161. Here, the concentration of the doping material may mean an atomic percent. For example, each of the second layer 162 and the third layer 163 may include the same material as the first layer 161. For example, each of the first layer 161, the second layer 162, and the third layer 163 may include silicon (Si) doped with boron (B). In this case, a concentration of boron (B) contained in each of the second layer 162 and the third layer 163 may be equal to or greater than a concentration of boron (B) contained in the first layer 161. In some other embodiments, each of the second layer 162 and the third layer 163 may include a different material from the first layer 161.

The fourth layer 164 and the fifth layer 165 may each include silicon (Si) and/or silicon germanium (SiGe).

The front interlayer insulating film 175 may be disposed on the back interlayer insulating film 180 and the field insulating film 105. The front interlayer insulating film 175 may be disposed on the source/drain pattern 160. The front interlayer insulating film 175 may not cover the upper surface of the gate capping pattern 145. For example, an upper surface of the front interlayer insulating film 175 may be disposed on the same plane as the upper surface of the gate capping pattern 145.

The front interlayer insulating film 175 may include, for example, but not limited to, at least one of silicon oxide, silicon nitride, silicon oxynitride, and a low dielectric constant material.

A source/drain etching stop film 170 may extend along a profile of the source/drain pattern 160. The source/drain etching stop film 170 may be disposed between the source/drain pattern 160 and the front interlayer insulating film 175.

The source/drain etching stop film 170 may include at least one of but not limited to, for example, silicon nitride (SiN), silicon oxynitride (SiON), silicon oxycarbonitride (SiOCN), silicon boronitride (SiBN), silicon oxyboronitride (SiOBN), silicon oxycarbide (SiOC), and any combination thereof.

A front spacer 140 may be disposed on a side wall of the gate spacer 130. The front spacer 140 may be disposed between the source/drain etching stop film 170 and the gate spacer 130. The front spacer 140 may include an insulating material. The front spacer 140 may include a material different from the source/drain etching stop film 170. For example, the front spacer 140 may include silicon nitride (SiN), and the source/drain etching stop film 170 may include a material different from silicon nitride (SiN).

In some embodiments, the back source/drain contact 195 may elongatedly extend in the vertical direction DR3. The back source/drain contact 195 may be electrically connected to the source/drain pattern 160. The back source/drain contact 195 may be electrically connected to a back wiring line disposed on a bottom surface of the back interlayer insulating film 180. The back wiring line may be a power line that supplies power to the semiconductor device, or a signal line that supplies an operating signal of the semiconductor device. Here, the back source/drain contact 195 may be referred to as a source/drain contact.

The back source/drain contact 195 may be disposed inside the back interlayer insulating film 180. The back source/drain contact 195 may extend from the bottom surface to the upper surface of the back interlayer insulating film 180. The back source/drain contact 195 may penetrate the back interlayer insulating film 180.

The back source/drain contact 195 may be disposed inside the source/drain pattern 160. The back source/drain contact 195 may enter the source/drain pattern 160. The back source/drain contact 195 may penetrate a part of the source/drain pattern 160. An upper surface of the back source/drain contact 195 may be disposed inside the source/drain pattern 160. The upper surface of the back source/drain contact 195 may have a convex shape toward the source/drain pattern 160.

In some embodiments, the back source/drain contact 195 may enter the second layer 162. The upper surface of the back source/drain contact 195 may be disposed inside the second layer 162. The back source/drain contact 195 may penetrate the fourth layer 164 and a part of the second layer 162.

The back source/drain contact 195 may include a conductive material. The back source/drain contact 195 may include at least one of, for example, but not limited to, a metal, a conductive metal nitride, a conductive metal carbide, a conductive metal oxide, a conductive metal oxynitride, a conductive metal silicon nitride, a conductive metal carbonitride, and a two-dimensional material. Although the back source/drain contact 195 is shown as being a single film, this is only for convenience of explanation, and the embodiment is not limited thereto. Unlike the shown example, the first back source/drain contact 195 may have a multi-conductive film structure. The back source/drain contact 195 may include, for example, a back contact barrier film and a back contact filling film.

A back contact silicide film 190 may be disposed between the back source/drain contact 195 and the source/drain pattern 160. The back contact silicide film 190 may come into contact with the back source/drain contact 195 and the source/drain pattern 160. The back contact silicide film 190 may come into contact with the back source/drain contact 195 and the second layer 162. The back contact silicide film 190 may include a metal silicide material.

In the semiconductor device according to some embodiments, because the back contact silicide film 190 comes into contact with the second layer 162 of the source/drain pattern 160, which is doped with a doping material at a higher concentration than the first layer 161, a contact resistance between the back source/drain contact 195 and the source/drain pattern 160 may be lowered. Therefore, performance and reliability of the semiconductor device according to some embodiments may be improved.

In some embodiments, a back spacer 185 may be disposed on a side wall of the back source/drain contact 195. The back spacer 185 may extend along the side wall of the back source/drain contact 195. The back spacer 185 may be disposed between the back interlayer insulating film 180 and the back source/drain contact 195. The back spacer 185 may include an insulating material. The back spacer 185 may include, for example, but not limited to, silicon nitride (SiN).

Referring to FIG. 2, in some embodiments, a substrate pattern 100 may be disposed between the back interlayer insulating film 180 and the back spacer 185, and between the back interlayer insulating film 180 and the source/drain pattern 160.

The substrate pattern 100 may be bulk silicon, silicon-on-insulator (SOI), silicon, or may include other materials, for example, but not limited to, silicon germanium, silicon germanium on insulator (SGOI), indium antimonide, lead telluride, indium arsenide, indium phosphide, gallium arsenide or gallium antimonide.

Referring to FIG. 5, the semiconductor device according to one or more embodiments may not include the substrate pattern 100 of FIG. 2.

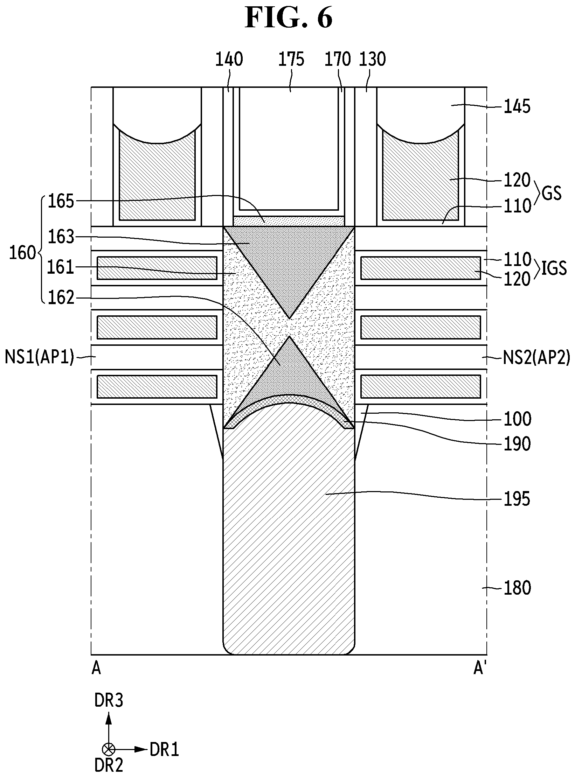

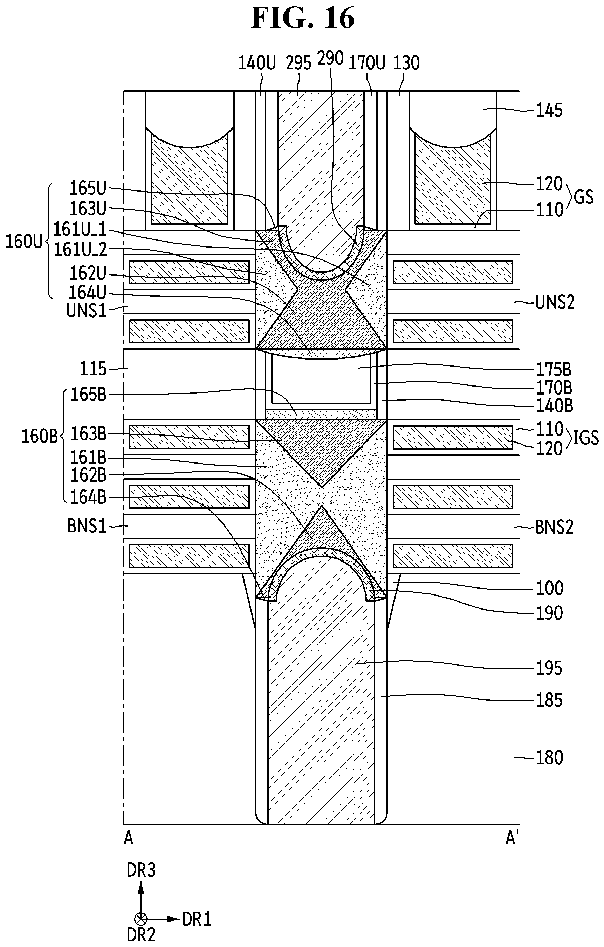

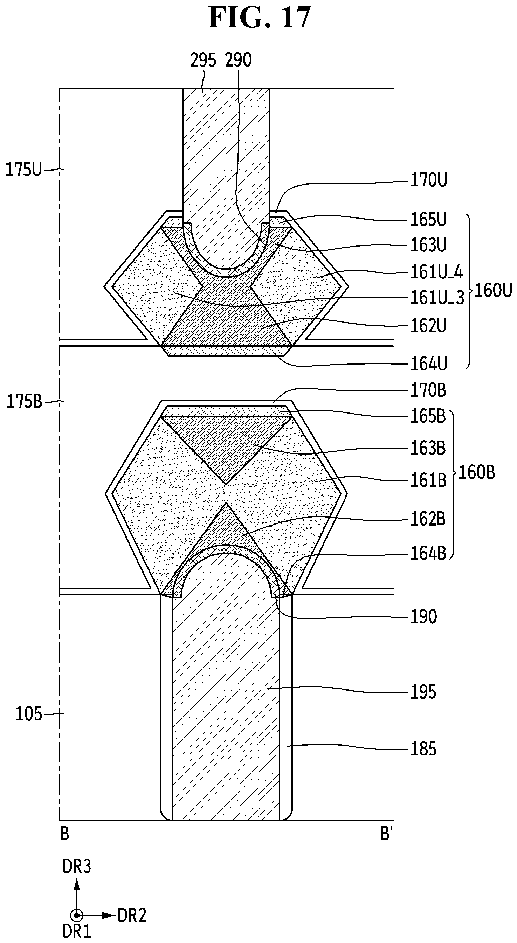

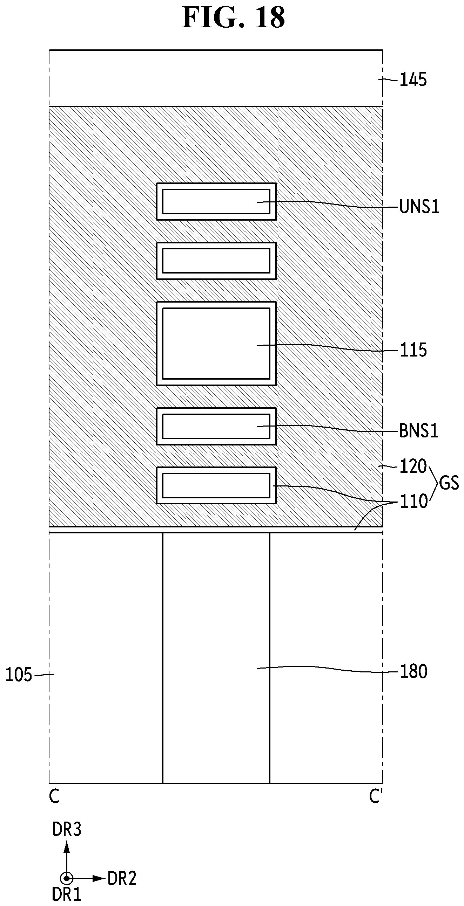

FIGS. 6 to 18 are diagrams for explaining a semiconductor device according to one or more embodiments. For convenience of explanation, differences from those described using FIGS. 1 to 5 will be mainly explained. For reference, FIGS. 6, 8, 10, 12, 14, and 16 are example cross-sectional views taken along A-A' of FIG. 1, FIGS. 7, 9, 11, 13, 15, and 17 are example cross-sectional views taken along B-B' of FIG. 1, and FIG. 18 is an example cross-sectional view taken along C-C' of FIG. 1.

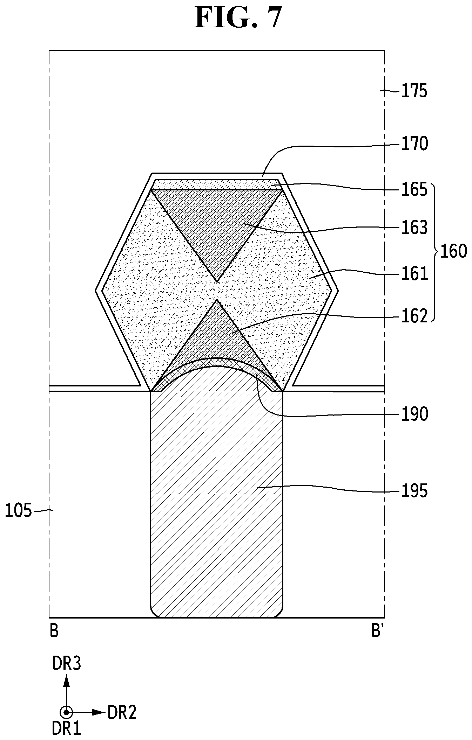

Referring to FIGS. 6 and 7, in the semiconductor device according to some embodiments, the back interlayer insulating film 180 may be disposed on the side wall of the back source/drain contact 195. A back spacer (e.g., 185 of FIG. 2) may not be disposed between the source/drain contact 195 and the back interlayer insulating film 180. The back source/drain contact 195 may come into contact with the back interlayer insulating film 180.

In some embodiments, the substrate pattern 100 may be disposed between the back source/drain contact 195 and the back interlayer insulating film 180. In contrast, in some alternative embodiments, the substrate pattern 100 may be omitted.

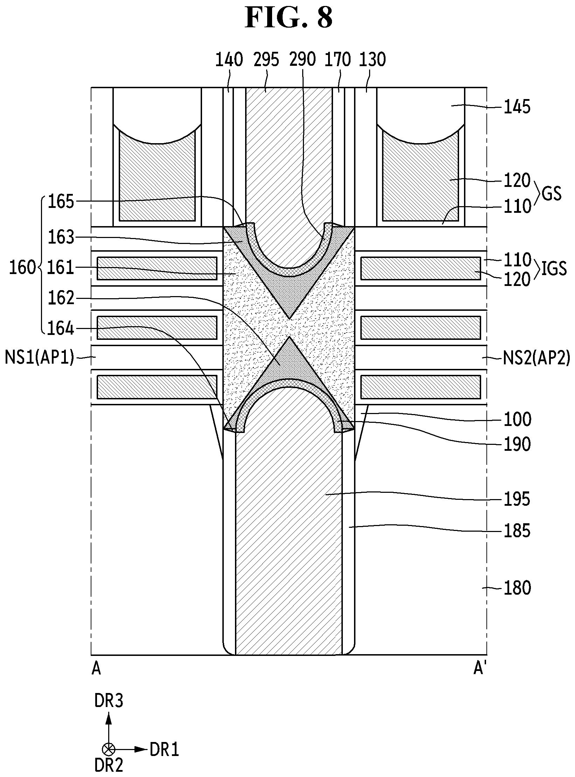

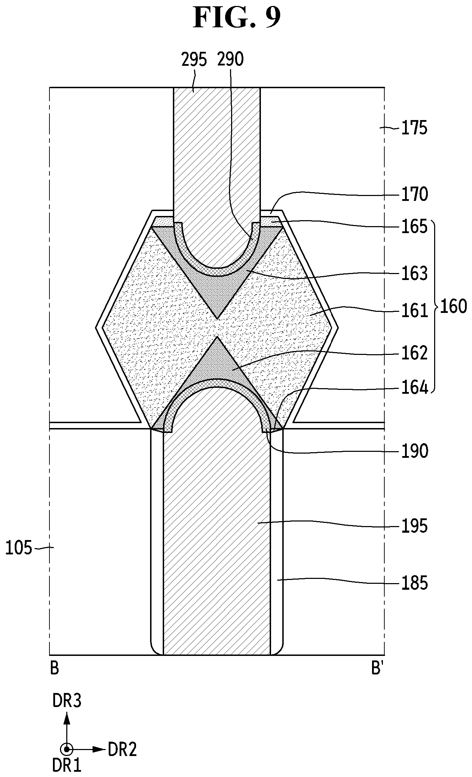

Referring to FIGS. 8 and 9, the semiconductor device according to some embodiments may further include a front contact silicide film 290 and a front source/drain contact 295. That is, the source/drain pattern 160 may be electrically connected to the front source/drain contact 295 and the back source/drain contact 195. Here, the front source/drain contact 295 may be referred to as a source/drain contact.

The front source/drain contact 295 may elongatedly extend in the vertical direction DR3. The front source/drain contact 295 may be electrically connected to the source/drain pattern 160. The front source/drain contact 295 may be electrically connected to a front wiring line disposed on the upper surface of the front interlayer insulating film 175.

A source/drain etching stop film 170 may be disposed between the front source/drain contact 295 and the front spacer 140. The front source/drain contact 295 may be disposed inside the front interlayer insulating film 175. The front source/drain contact 295 may extend from the upper surface to the bottom surface of the front interlayer insulating film 175. The front source/drain contact 295 may penetrate the front interlayer insulating film 175.

The front source/drain contact 295 may be disposed inside the source/drain pattern 160. The front source/drain contact 295 may enter the source/drain pattern 160. The front source/drain contact 295 may penetrate a part of the source/drain pattern 160. A bottom surface of the front source/drain contact 295 may be disposed inside the source/drain pattern 160. The bottom surface of the front source/drain contact 295 may have a convex shape toward the source/drain pattern 160.

In some embodiments, the front source/drain contact 295 may enter the third layer 163. The bottom surface of the front source/drain contact 295 may be disposed inside the third layer 163.

The front source/drain contact 295 may include, for example, but not limited to, at least one of a metal, a conductive metal nitride, a conductive metal carbide, a conductive metal oxide, a conductive metal carbonitride, and a two-dimensional material.

The front contact silicide film 290 may be disposed between the front source/drain contact 295 and the source/drain pattern 160. The front contact silicide film 290 may come into contact with the front source/drain contact 295 and the source/drain pattern 160. The front contact silicide film 290 may come into contact with the front source/drain contact 295 and the third layer 163. The front contact silicide film 290 may include, for example, but not limited to, a metal silicide material.

In the semiconductor device according to some embodiments, because the front source/drain contact 295 comes into contact with the third layer 163 of the source/drain pattern 160, which is doped with a doping material at a higher concentration than the first layer 161, a contact resistance between the front source/drain contact 295 and the source/drain pattern 160 may be lowered. Thus, performance and reliability of the semiconductor device according to some embodiments may be improved.

In some embodiments, the substrate pattern 100 may be omitted. In some embodiments, the back spacer 185 may be omitted.

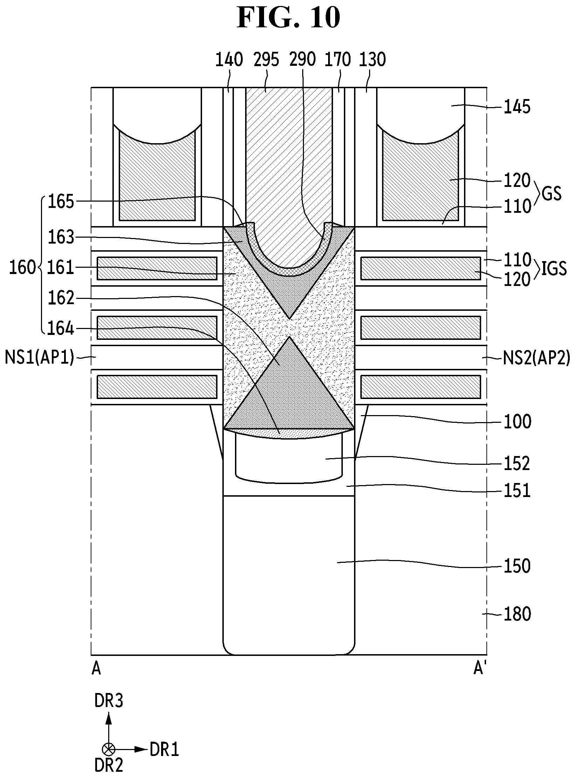

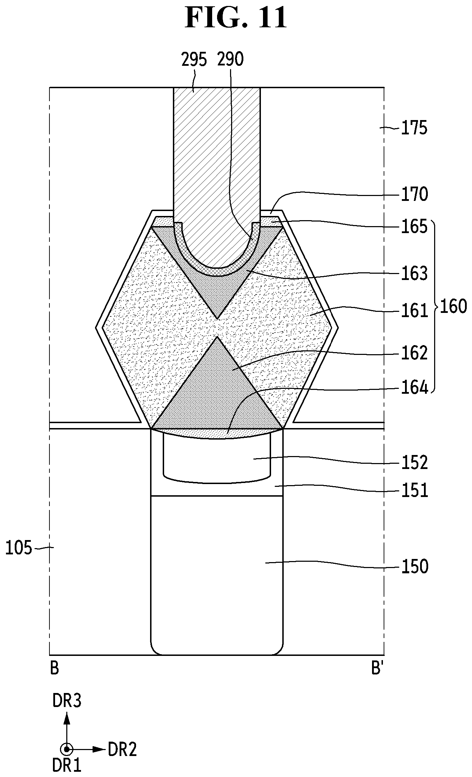

Referring to FIGS. 10 and 11, the semiconductor device according to some embodiments may include a front contact silicide film 290, a front source/drain contact 295, a sacrificial pattern 150, a sacrificial spacer 151, and a sacrificial filling film 152.

The source/drain pattern 160 may be electrically connected to the front source/drain contact 295. The front source/drain contact 295 and the front contact silicide film 290 may be substantially the same as the front source/drain contact 295 and the front contact silicide film 290 described using FIGS. 8 and 9.

The sacrificial pattern 150 may be disposed inside the back interlayer insulating film 180. The sacrificial pattern 150 may come into contact with the back interlayer insulating film 180.

The sacrificial pattern 150 may be disposed on or below the source/drain pattern 160. The sacrificial pattern 150 may overlap the source/drain pattern 160 in the vertical direction DR3.

In some embodiments, the sacrificial pattern 150 may include a dielectric material.

In some embodiments, the sacrificial pattern 150 may include a semiconductor material. For example, the sacrificial pattern 150 may include silicon germanium (SiGe). A concentration of germanium (Ge) contained in the sacrificial pattern 150 may be different from a concentration of germanium (Ge) contained in the second layer 162 and the third layer 163. The concentration of germanium (Ge) contained in the sacrificial pattern 150 may be lower than the concentration of germanium (Ge) contained in the second layer 162 and the third layer 163.

The sacrificial spacer 151 and the sacrificial filling film 152 may be disposed on or below the source/drain pattern 160. The sacrificial spacer 151 and the sacrificial filling film 152 may be disposed between the source/drain pattern 160 and the sacrificial pattern 150. The sacrificial spacer may define a trench, and the sacrificial filling film 152 may fill the trench, between the source/drain pattern 160 and the sacrificial pattern 150. The sacrificial spacer 151 and the sacrificial filling film 152 may come into contact with the source/drain pattern 160 and the sacrificial pattern 150. The sacrificial spacer 151 may extend along a side wall and a bottom surface of the sacrificial filling film 152. Upper surfaces of the sacrificial spacer 151 and the sacrificial filling film 152 may come into contact with the fourth layer 164 of the source/drain pattern 160.

The sacrificial spacer 151 and the sacrificial filling film 152 may each include an insulating material. For example, the back spacer 185 may include silicon nitride (SiN), and the sacrificial filling film 152 may include Tonen Silazen (TOSZ).

In some embodiments, the substrate pattern 100 may be omitted.

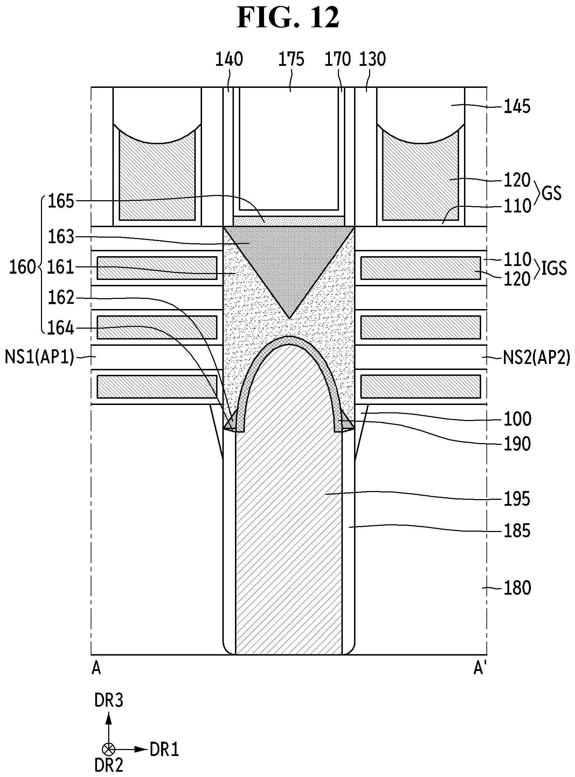

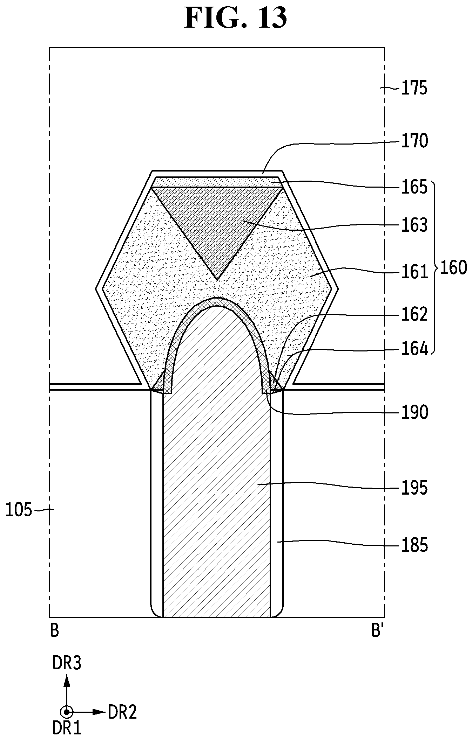

Referring to FIGS. 12 and 13, in the semiconductor device according to some embodiments, the back source/drain contact 195 may enter the first layer 161. The upper surface of the back source/drain contact 195 may be disposed inside the first layer 161. The back source/drain contact 195 may penetrate the fourth layer 164, the second layer 162, and a part of the first layer 161.

In some embodiments, the substrate pattern 100 may be omitted. In some embodiments, the back spacer 185 may be omitted.

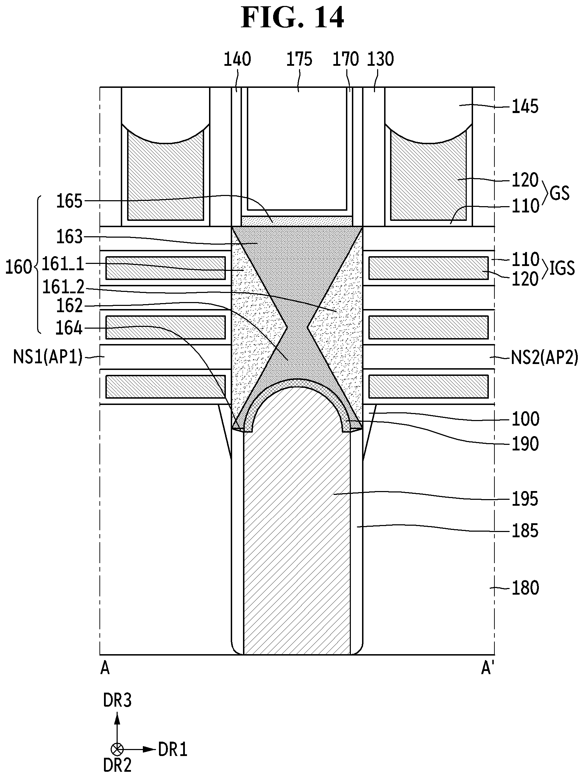

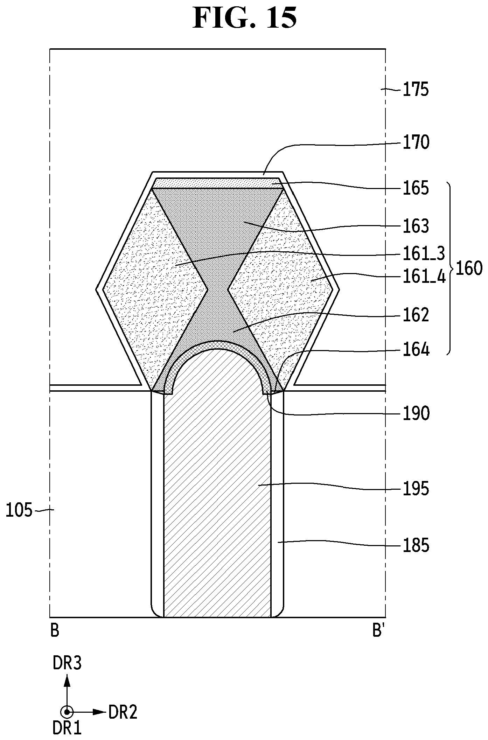

Referring to FIGS. 14 and 15, in the semiconductor device according to some embodiments, first layers 161_1, 161_2, 161_3, and 161_4 of the source/drain pattern 160 may include a first portion 161_1, a second portion 161_2, a third portion 161_3, and a fourth portion 161_4. The first portion 161_1 may come into contact with the first channel pattern NS1. The second portion 161_2 may come into contact with the second channel pattern NS2. The third portion 161_3 and the fourth portion 161_4 may be disposed between the second and third layers 162 and 163 and the front interlayer insulating film 175. The third portion 161_3 and the fourth portion 161_4 may be opposite to each other in the second horizontal direction DR2. From a viewpoint of a plan view including the first horizontal direction DR1 and the second horizontal direction DR2, the first to fourth portions 161_1, 161_2, 161_3, and 161_4 may have a shape that surrounds the second layer 162 and the third layer 163.

A width of the first portion 161_1 in the vertical direction DR3 may decrease along a direction away from the first channel pattern NS1. A width of the second portion 161_2 in the vertical direction DR3 may decrease along a direction away from the second channel pattern NS2. A width of the third portion 161_3 in the vertical direction DR3 may increase and then decrease along a direction approaching the fourth portion 161_4. A width of the fourth portion 161_4 in the vertical direction DR3 may increase and then decrease along a direction approaching the third portion 161_3. In the cross-section shown in FIG. 14, the first portion 161_1 and the second portion 161_2 may be spaced apart from each other. In the cross-section shown in FIG. 14, the first portion 161_1 and the second portion 161_2 may not be connected to each other. In the cross-section shown in FIG. 15, the third portion 161_3 and the fourth portion 161_4 may be spaced apart from each other. In the cross-section shown in FIG. 15, the third portion 161_3 and the fourth portion 161_4 may not be connected to each other.

The second layer 162 and the third layer 163 may be connected to each other. The second layer 162 and the third layer 163 may fill spaces between the first to fourth portions 161_1, 161_2, 161_3, and 161_4.

Although the drawings show that a side wall of the first portion 161_1 opposite to the second portion 161_2 is pointed toward the second portion 161_2, a side wall of the second portion 161_2 opposite to the first portion 161_1 is pointed toward the second portion 161_1, a side wall of the third portion 161_3 opposite to the fourth portion 161_4 is pointed toward the fourth portion 161_4, and a side wall of the fourth portion 161_4 opposite to the third portion 161_3 is pointed toward the third portion 161_3, the embodiments are not limited thereto. Unlike the shown examples, at least one of the side wall of the first portion 161_1 opposite to the second portion 161_2, the side wall of the second portion 161_2 opposite to the first portion 161_1, the side wall of the third portion 161_3 opposite to the fourth portion 161_4, and the side wall of the fourth portion 161_4 opposite to the third portion 161_3 may include a flat portion. For example, a width of the first portion 161_1 in the first horizontal direction DR1 and a width of the second portion 161_2 in the first horizontal direction DR1 may increase, be constant, and then decrease along a direction approaching the fifth layer 165 from the fourth layer 164.

In some embodiments, the source/drain pattern 160 may include a p-type dopant as described using FIGS. 1 to 5.

In some embodiments, the source/drain pattern 160 may include an n-type dopant. The first layers 161_1, 161_2, 161_3, and 161_4 may include silicon (Si) doped with the n-type dopant. The second layer 162 and the third layer 163 may each include silicon (Si). The fourth layer 164 and the fifth layer 165 may each include silicon (Si) and/or silicon germanium (SiGe).

In some embodiments, the substrate pattern 100 may be omitted. In some embodiments, the back spacer 185 may be omitted.

Referring to FIGS. 1 and 16 to 18, in the semiconductor device according to some embodiments, the first active pattern AP1 may include a first lower channel pattern BNS1 and a first upper channel pattern UNS1, and the second active pattern AP2 may include a second lower channel pattern BNS2 and a second upper channel pattern UNS2.

At least one or more first lower channel patterns BNS1 may be disposed on the back interlayer insulating film 180. When a plurality of first lower channel patterns BNS1 are disposed on the back interlayer insulating film 180, each first lower channel pattern BNS1 may be spaced apart from the back interlayer insulating film 180 in the vertical direction DR3. Each of the first lower channel patterns BNS1 may be spaced apart from each other in the vertical direction DR3. Although two first lower channel patterns BNS1 are shown as being disposed on the upper surface of the back interlayer insulating film 180, the embodiment is not limited thereto. Unlike the shown example, one or three or more first lower channel patterns BNS1 may be disposed on the upper surface of the back interlayer insulating film 180.

At least one or more first upper channel patterns UNS1 may be disposed on the upper surface of the back interlayer insulating film 180. The first upper channel pattern UNS1 may be disposed on the first lower channel pattern BNS1. The first lower channel pattern BNS1 may be disposed between the back interlayer insulating film 180 and the first upper channel pattern UNS1.

The first upper channel pattern UNS1 may be spaced apart from the first lower channel pattern BNS1 in the vertical direction DR3. When each first upper channel pattern UNS1 is disposed on the upper surface of the first back interlayer insulating film 180, the plurality of first upper channel patterns UNS1 may be spaced apart from each other in the vertical direction DR3. Although two first upper channel patterns UNS1 are shown as being disposed on the upper surface of the back interlayer insulating film 180, the embodiment is not limited thereto. Unlike the shown example, one or three or more first upper channel patterns UNS1 may be disposed on the upper surface of the back interlayer insulating film 180. Although a number of first upper channel patterns UNS1 is shown as being the same as a number of first lower channel patterns BNS1, this is only for convenience of explanation, and the embodiment is not limited thereto.

At least one or more second lower channel patterns BNS2 may be disposed on the back interlayer insulating film 180. When a plurality of second lower channel patterns BNS2 are disposed on the back interlayer insulating film 180, each second lower channel pattern BNS2 may be spaced apart from the back interlayer insulating film 180 in the vertical direction DR3. Each of the second lower channel patterns BNS2 may be spaced apart from each other in the vertical direction DR3. Although two second lower channel patterns BNS2 are shown as being disposed on the upper surface of the back interlayer insulating film 180, the embodiment is not limited thereto. Unlike the shown example, one or three or more second lower channel patterns BNS2 may be disposed on the upper surface of the back interlayer insulating film 180.

At least one or more second upper channel patterns UNS2 may be disposed on the upper surface of the back interlayer insulating film 180. The second upper channel pattern UNS2 may be disposed on the second lower channel pattern BNS2. The second lower channel pattern BNS2 may be disposed between the back interlayer insulating film 180 and the second upper channel pattern UNS2.

The second upper channel pattern UNS2 may be spaced apart from the second lower channel pattern BNS2 in the vertical direction DR3. When each second upper channel pattern UNS2 is disposed on the upper surface of the first back interlayer insulating film 180, the plurality of second upper channel patterns UNS2 may be spaced apart from each other in the vertical direction DR3. Although two second upper channel patterns UNS2 are shown as being disposed on the upper surface of the back interlayer insulating film 180, the embodiment is not limited thereto. Unlike the shown example, one or three or more second upper channel patterns UNS2 may be disposed on the upper surface of the back interlayer insulating film 180. Although a number of second upper channel patterns UNS2 is shown as being the same as a number of second lower channel patterns BNS2, this is only for convenience of explanation, and the embodiment is not limited thereto.

A channel separation pattern 115 may be disposed between the first lower channel pattern BNS1 and the first upper channel pattern UNS1. The channel separation pattern 115 may be disposed between the second lower channel pattern BNS2 and the second upper channel pattern UNS2. The channel separation pattern 115 may be spaced apart from the first lower channel pattern BNS1 and the second lower channel pattern BNS2 in the vertical direction DR3. The channel separation pattern 115 may be spaced apart from the first upper channel pattern UNS1 and the second upper channel pattern UNS2 in the vertical direction DR3.

The channel separation pattern 115 may include an insulating material. For example, the channel separation pattern 115 may include at least one of silicon nitride, silicon oxycarbonitride, silicon boron carbonitride, silicon carbonitride, silicon oxide, silicon oxynitride, and any combination thereof.

The gate structure GS may surround the first lower channel pattern BNS1 and the first upper channel pattern UNS1. For example, in a cross-sectional view taken in the second horizontal direction DR2 and the vertical direction DR3, the gate structure GS may surround a periphery of the first lower channel pattern BNS1 and a periphery of the first upper channel pattern UNS1. The gate structure GS may surround the channel separation pattern 115. The gate structure GS may surround the second lower channel pattern BNS2 and the second upper channel pattern UNS2. For example, in the cross-sectional view taken in the second horizontal direction DR2 and the vertical direction DR3, the gate structure GS may surround a periphery of the second lower channel pattern BNS2 and a periphery of the second upper channel pattern UNS2.

The gate electrode 120 may surround the first lower channel pattern BNS1, the first upper channel pattern UNS1, the channel separation pattern 115, the second lower channel pattern BNS2, and the second upper channel pattern UNS2. In other words, the first lower channel pattern BNS1, the first upper channel pattern UNS1, the channel separation pattern 115, the second lower channel pattern BNS2, and the second upper channel pattern UNS2 may penetrate the gate electrode 120.

The gate structure GS may include inner gate structures IGS which are disposed between the first lower channel patterns BNS1 adjacent to each other in the vertical direction DR3, between the first upper channel patterns UNS1 adjacent to each other in the vertical direction DR3, between the back interlayer insulating film 180 and the first lower pattern NS1 adjacent to each other in the vertical direction DR3, between the second lower channel patterns BNS2 adjacent to each other in the vertical direction DR3, between the second upper channel patterns UNS2 adjacent to each other in the vertical direction DR3, and between the back interlayer insulating film 180 and the second lower pattern NS2 adjacent to each other in the vertical direction DR3.

The gate insulating film 110 may be disposed between the first lower channel pattern BNS1 and the gate electrode 120, between the first upper channel pattern UNS1 and the gate electrode 120, between the channel separation pattern 115 and the gate electrode 120, between the second lower channel pattern BNS2 and the gate electrode 120, and between the second upper channel pattern UNS2 and the gate electrode 120. The gate insulating film 110 may be disposed along the periphery of the first lower channel pattern BNS1, the periphery of the first upper channel pattern UNS1, a periphery of the channel separation pattern 115, the periphery of the second lower channel pattern BNS2, and the periphery of the second upper channel pattern UNS2.

The gate spacer 130 may not be disposed between the back interlayer insulating film 180 and the first lower channel pattern BNS1, between the first lower channel patterns BNS1 adjacent in the vertical direction DR3, between the back interlayer insulating film 180 and the second lower channel pattern BNS2, and between the second lower channel patterns BNS2 adjacent in the vertical direction DR3. The gate spacer 130 may not be disposed between the channel separation pattern 115 and the first upper channel pattern UNS1, between the first upper channel patterns UNS1 adjacent in the vertical direction DR3, between the channel separation pattern 115 and the second upper channel pattern UNS2, and between the second upper channel patterns UNS1 adjacent in the vertical direction DR3. The gate spacer 130 may not be disposed between the channel separation pattern 115 and the first lower channel pattern BNS1, and between the channel separation pattern 115 and the second lower channel pattern BNS2.

A lower source/drain pattern 160B may be disposed on the back interlayer insulating film 180. The lower source/drain pattern 160B may be disposed on at least one side surface of the gate electrode 120. The lower source/drain pattern 160B may be disposed between the gate electrodes 120 adjacent in the first horizontal direction DR1.

The lower source/drain pattern 160B may be disposed between the first lower channel pattern BNS1 and the second lower channel pattern BNS2. The lower source/drain pattern 160B may come into contact with the first lower channel pattern BNS1 and the second lower channel pattern BNS2. The lower source/drain pattern 160B may be connected to the end of the first lower channel pattern BNS1 and the end of the second lower channel pattern BNS2 that are opposite to each other.

An upper source/drain pattern 160U may be disposed on the lower source/drain pattern 160B. The upper source/drain pattern 160U may be spaced apart from the lower source/drain pattern 160B in the vertical direction DR3.

The upper source/drain pattern 160U may be disposed on at least one side surface of the gate electrode 120. The upper source/drain pattern 160U may be disposed between the gate electrodes 120 adjacent in the first horizontal direction DR1.

The upper source/drain pattern 160U may be disposed between the first upper channel pattern UNS1 and the second upper channel pattern UNS2. The upper source/drain pattern 160U may come into contact with the first upper channel pattern UNS1 and the second upper channel pattern UNS2. The upper source/drain pattern 160U may be connected to the end of the first upper channel pattern UNS1 and the end of the second upper channel pattern UNS2 that are opposite to each other.

The first lower channel pattern BNS1 and the first upper channel pattern UNS1 may be included in transistors of different conductivity types from each other.

The lower source/drain pattern 160B may include a first lower layer 161B, a second lower layer 162B, a third lower layer 163B, a fourth lower layer 164B, and a fifth lower layer 165B. The description of the first lower layer 161B, the second lower layer 162B, the third lower layer 163B, the fourth lower layer 164B, and the fifth lower layer 165B may be substantially the same as the description of the first layer 161, the second layer 162, the third layer 163, the fourth layer 164, and the fifth layer 165 described using FIGS. 1 to 4, respectively. The upper source/drain pattern 160U may include first upper layers 161U_1, 161U_2, 161U _3, and 161U_4, a second upper layer 162U, a third upper layer 163U, a fourth upper layer 164U, and a fifth upper layer 165U. The description of the first upper layers 161U_1, 161U_2, 161U_3, and 161U_4, the second upper layer 162U, the third upper layer 163U, the fourth upper layer 164U, and the fifth upper layer 165U may be substantially the same as the description of the first layers 161_1, 161_2, 161_3, and 161_4, the second layer 162, the third layer 163, the fourth layer 164, and the fifth layer 165 described using FIGS. 14 and 15, respectively.

In some embodiments, the first lower channel pattern BNS1 and the second lower channel pattern BNS2 may be used as a channel region of a p-type transistor, the lower source/drain pattern 160B may be included in the source/drain of the p-type transistor, and the lower source/drain pattern 160B may include a p-type dopant. The first upper channel pattern UNS1 and the second upper channel pattern UNS2 may be used as a channel region of an n-type transistor, the upper source/drain pattern 160U may be included in the source/drain of the n-type transistor, and the upper source/drain pattern 160U may include an n-type dopant.

In some other embodiments,, the first lower channel pattern BNS1 and the second lower channel pattern BNS2 may be used as a channel region of an n-type transistor, the lower source/drain pattern 160B may be included in the source/drain of the n-type transistor, and the lower source/drain pattern 160B may include an n-type dopant. The first upper channel pattern UNS1 and the second upper channel pattern UNS2 may be used as a channel region of a p-type transistor, the upper source/drain pattern 160U may be included in the source/drain of the p-type transistor, and the upper source/drain pattern 160U may include a p-type dopant.

A lower front interlayer insulating film 175B may be disposed on the upper surface of the back interlayer insulating film 180. The lower front interlayer insulating film 175B may cover the lower source/drain pattern 160B.

The upper source/drain pattern 160U may be disposed on the lower front interlayer insulating film 175B. The lower front interlayer insulating film 175B may be disposed between the lower source/drain pattern 160B and the upper source/drain pattern 160U.

A lower source/drain etching stop film 170B may extend along a profile of the lower source/drain pattern 160B. The lower source/drain etching stop film 170B may be disposed between the lower source/drain pattern 160B and the lower front interlayer insulating film 175B. The lower source/drain etching stop film 170B may extend along a profile of the upper surface of the back interlayer insulating film 180.

Unlike the shown example, the lower source/drain etching stop film 170B may not be disposed between the lower source/drain pattern 160B and the lower front interlayer insulating film 175B.

A lower front spacer 140B may be disposed on a side wall of the gate spacer 130. The lower front spacer 140B may be disposed between the lower source/drain etching stop film 170B and the channel separation pattern 115.

An upper front interlayer insulating film 175U may be disposed on the lower front interlayer insulating film 175B. The upper front interlayer insulating film 175U may cover the upper source/drain pattern 160U.

An upper source/drain etching stop film 170U may be disposed between the upper front interlayer insulating film 175U and the upper source/drain pattern 160U. The upper source/drain etching stop film 170U may extend along at least a part of a profile of the upper source/drain pattern 160U.

Unlike the shown example, the upper front interlayer insulating film 175U and the lower front interlayer insulating film 175B may not be separated by the upper source/drain etching stop film 170U.

The lower front interlayer insulating film 175B and the upper front interlayer insulating film 175U may each include at least one of, for example, but not limited to, silicon oxide, silicon nitride, silicon oxynitride, and a low dielectric constant material. The lower source/drain etching stop film 170B and the upper source/drain etching stop film 170U may each include at least one of, for example, but not limited to, silicon nitride, silicon oxynitride, silicon oxycarbonitride, silicon boron nitride, silicon oxyboron nitride, silicon carbonitride, silicon oxycarbide, and any combination thereof.

The back contact silicide film 190 may be disposed between the back source/drain contact 195 and the lower source/drain pattern 160B. The front source/drain contact 295 may be disposed in the upper front interlayer insulating film 175U. The front source/drain contact 295 may be electrically connected to the upper source/drain pattern 160U. The front contact silicide film 290 may be disposed between the front source/drain contact 295 and the upper source/drain pattern 160U.

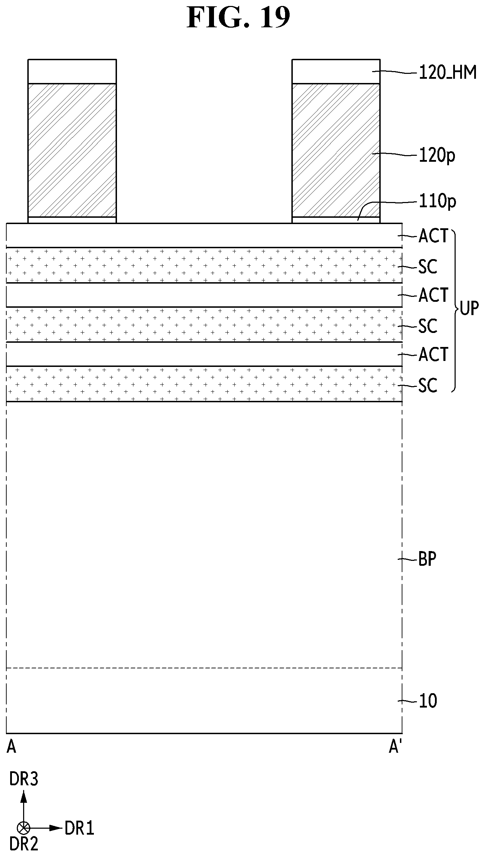

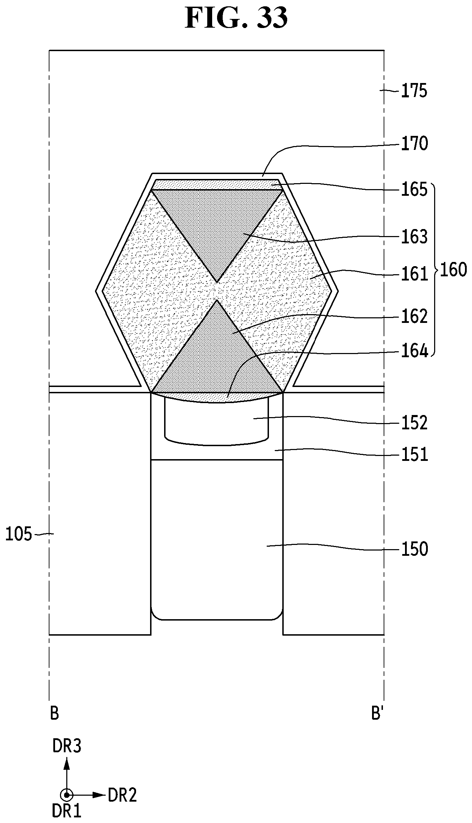

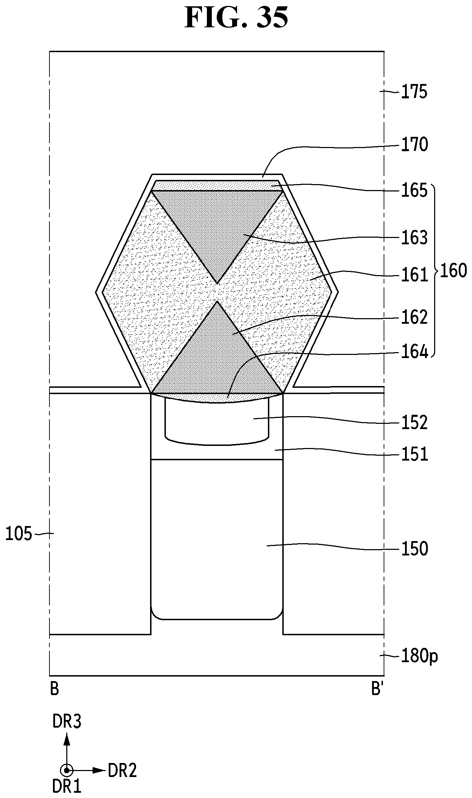

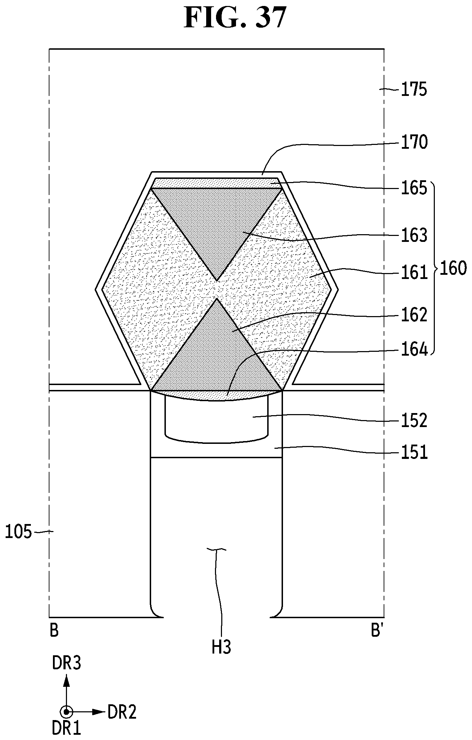

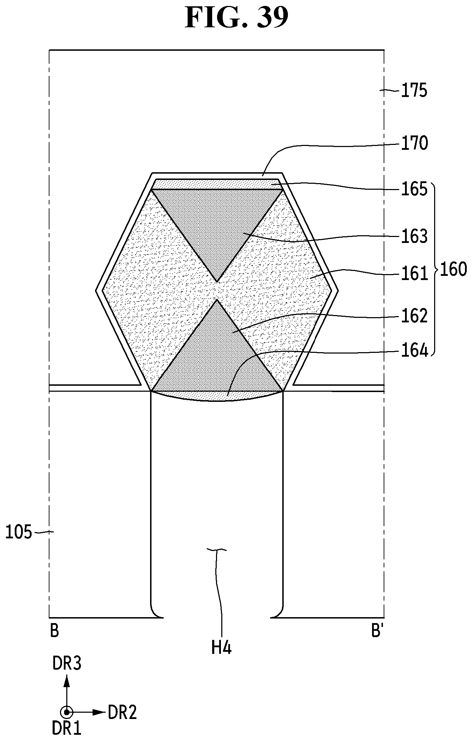

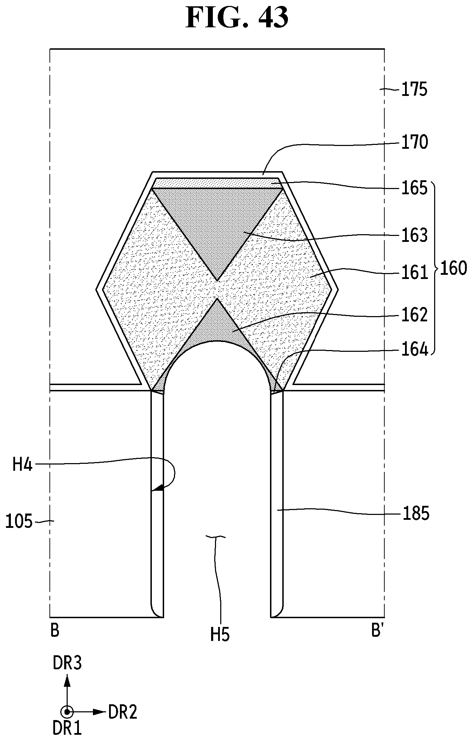

FIGS. 19 to 43 are intermediate stage diagrams for describing a method for fabricating a semiconductor device according to one or more embodiments.

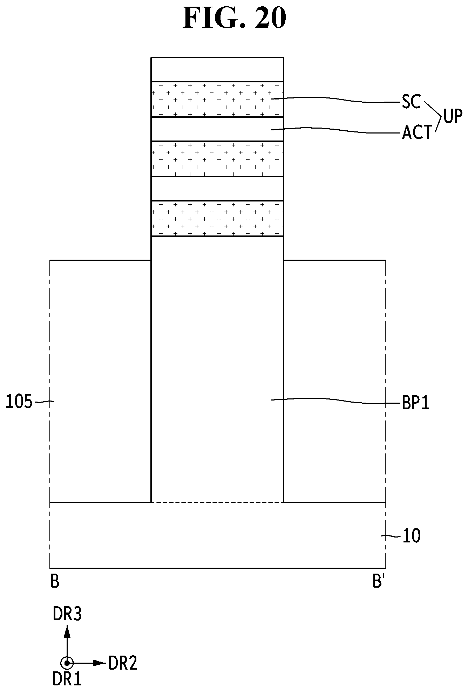

Referring to FIGS. 19 and 20, a lower pattern BP, the field insulating film 105, and an upper pattern structure UP may be formed on the substrate 10.

The substrate 10 may be bulk silicon or silicon-on-insulator (SOI). In contrast, the substrate 10 may be a silicon substrate, or may include other materials, for example, but not limited to, silicon germanium, silicon germanium on insulator (SGOI), indium antimonide, lead telluride, indium arsenide, indium phosphide, gallium arsenide or gallium antimonide.

The lower pattern BP may be disposed on the substrate 10. The lower pattern BP may protrude from an upper surface of the substrate 10 in the vertical direction DR3. The lower patterns BP may be spaced apart in the first horizontal direction DR1.

The field insulating film 105 may be disposed between the lower patterns BP. The field insulating film 105 may come into contact with side walls of the lower pattern BP and the upper surface of the substrate 10.

The upper pattern structure UP may be disposed on the lower pattern BP. The upper pattern structure UP may include a plurality of sacrificial films SC and a plurality of active patterns ACT which are alternately stacked on the lower pattern BP.

For example, the sacrificial film SC may include a silicon-germanium film, and the active pattern ACT may include a silicon film.

Next, a dummy gate insulating film 110p, a dummy gate electrode 120p, and a dummy gate capping film 120_HM may be formed on the upper pattern structure UP. The dummy gate insulating film 110p may include, for example, but not limited to, a silicon oxide. The dummy gate electrode 120p may include, for example, but not limited to, polysilicon. The dummy gate capping film 120_HM may include, for example, but not limited to, silicon nitride.

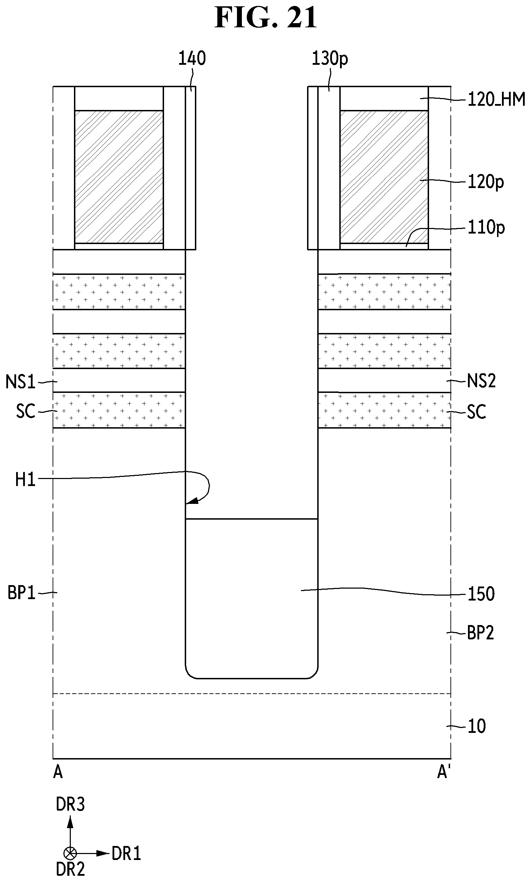

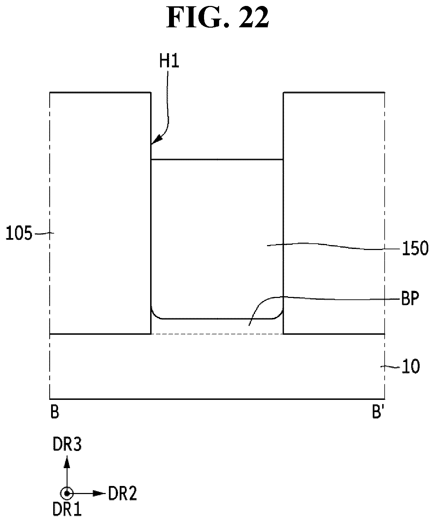

Referring to FIGS. 21 and 22, a pre-gate spacer 130p may be formed on a side wall of the dummy gate electrode 120p.

A first hole H1 may be formed in the upper pattern structure (e.g., UP of FIGS. 19 and 20), using the dummy gate electrode 120p as a mask. The first hole H1 may be formed in a lower pattern (e.g., BP of FIGS. 19 and 20). The lower pattern (e.g., BP of FIGS. 19 and 20) may be separated by the first hole H1 to form a first lower pattern BP1 and a second lower pattern BP2. The active pattern (e.g., ACT of FIGS. 19 and 20) may be separated by the first hole H1 to form first and second channel patterns NS1 and NS2.

Next, a front spacer 140 may be formed on a side wall of the pre-gate spacer 130p. The front spacer 140 may expose a side surface of the first channel pattern NS1, a side surface of the second channel pattern NS2, and a side surface of the sacrificial film SC.

Next, a sacrificial pattern 150 that fills a part of the first hole H1may be formed. An upper surface of the sacrificial pattern 150 may be disposed below a bottom surface of a lowermost sacrificial film SC.

In some embodiments, the sacrificial pattern 150 may be formed using an epitaxial growth method. The sacrificial pattern 150 may, for example, grow from the substrate 10 in a bottom-up manner.

In some embodiments, the sacrificial pattern 150 may include a dielectric material.

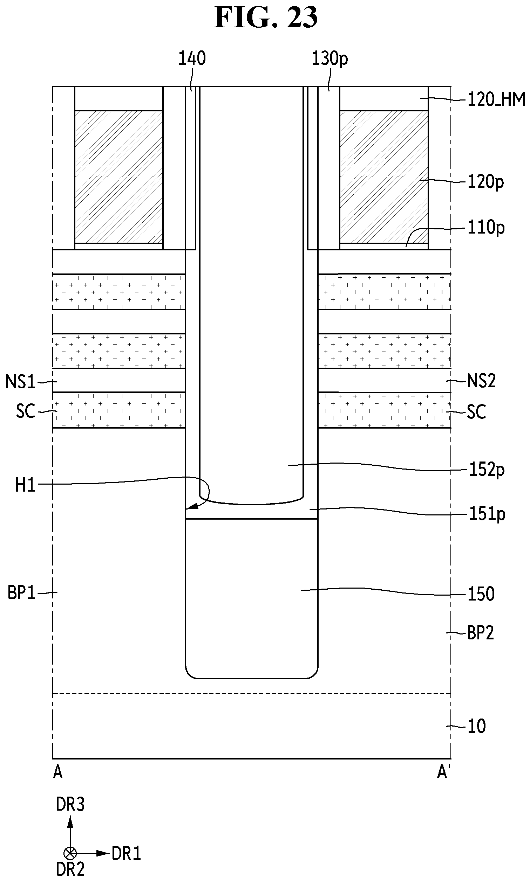

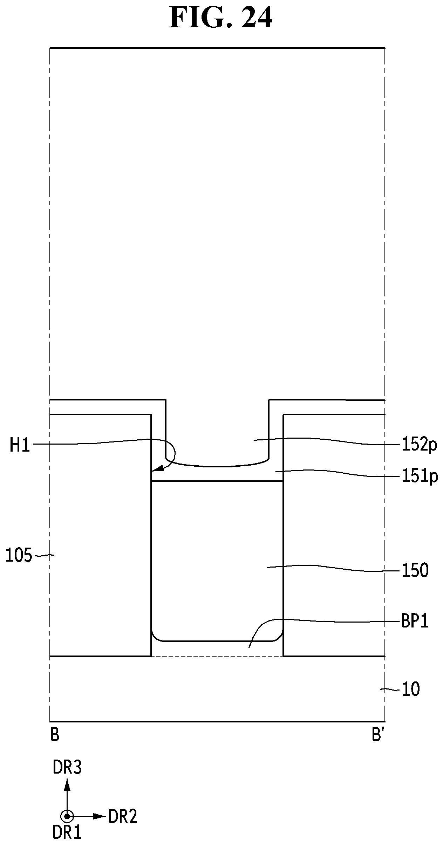

Referring to FIGS. 23 and 24, a pre-sacrificial spacer 151p and a pre-sacrificial filling film 152p may be formed on the sacrificial pattern 150. The pre-sacrificial spacers 151p may extend along the first holes H1 on the sacrificial pattern 150. The pre-sacrificial spacers 151p may extend along the upper surface of the sacrificial pattern 150, the side surfaces of the first holes H1, and the side surfaces of the front spacers 140. The pre-sacrificial spacers 151p may extend along the upper surface of the field insulating film 105. The pre-sacrificial filling film 152p may fill the first holes H1 on the pre-sacrificial spacers 151p. The pre-sacrificial filling film 152p may cover the field insulating film 105 on the sacrificial spacers 151p.

The pre-sacrificial spacer 151p may include a material different from that of the front spacer 140. The pre-sacrificial spacer 151p and the front spacer 140 may include different materials from each other among SiN, SiCN, SiOCN, SiBCN, and SiBN.

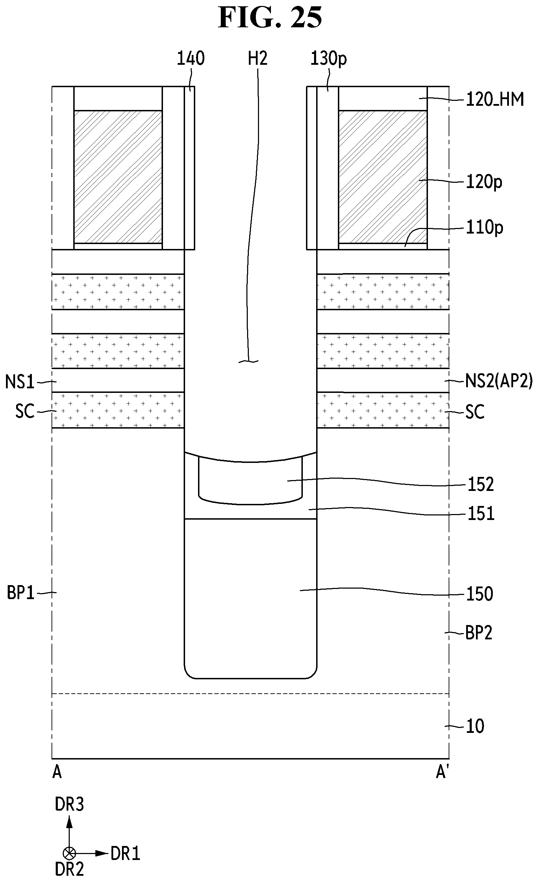

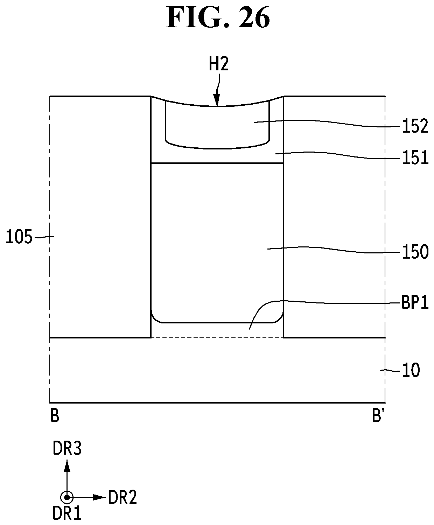

Referring to FIGS. 25 and 26, a part of the pre-sacrificial spacer 151p and a part of the pre-sacrificial filling film 152p may be removed to form the sacrificial spacer 151 and the sacrificial filling film 152. The sacrificial spacer 151 and the sacrificial filling film 152 may expose a side surface of the first channel pattern NS1, a side surface of the second channel pattern NS2, and a side surface of the sacrificial film SC. A region remaining on the upper surface of the sacrificial spacer 151 and the sacrificial filling film 152 inside the first hole (e.g., H1 of FIGS. 23 and 24) may be defined as a second hole H2.

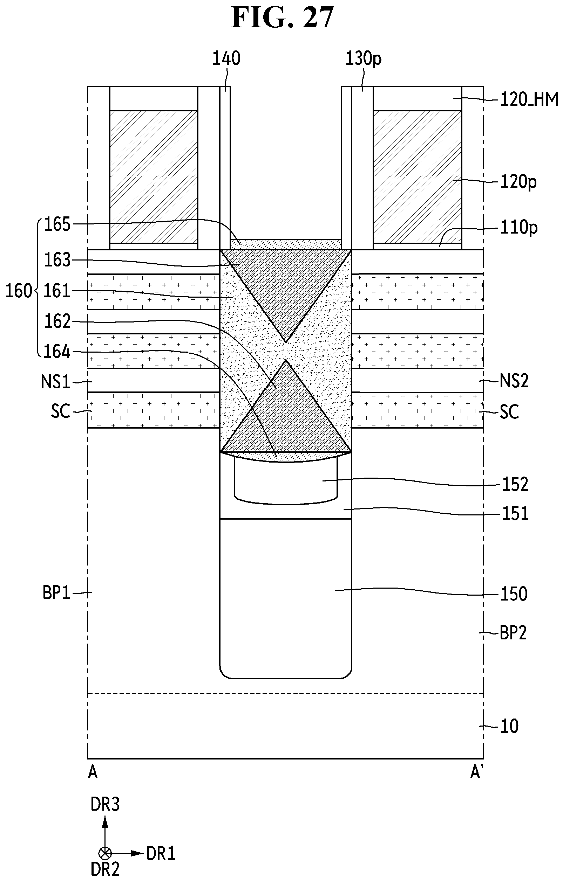

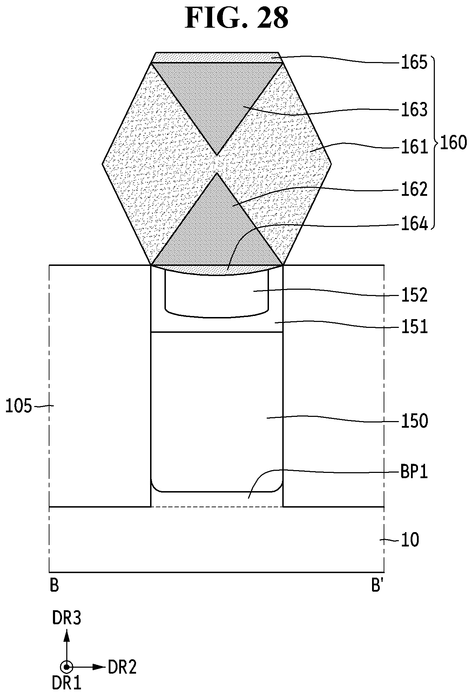

Referring to FIGS. 27 and 28, a source/drain pattern 160 may be formed on the sacrificial spacer 151 and the sacrificial filling film 152. The source/drain pattern 160 that fills a part of the second hole H2 may be formed.

The first layer 161 may be formed by an epitaxial growth from the side walls of the first channel pattern NS1 and the second channel pattern NS2 in the first horizontal direction DR1. The first layer 161 may grow in a horizontal direction (e.g., the first horizontal direction DR1 and/or the second horizontal direction DR2). The first layer 161 may come into contact with the first channel pattern NS1 and the second channel pattern NS2. A thickness in the vertical direction DR3 of the first end portion of the first layer 161 that comes into contact with the side wall of the first channel pattern NS1, and a thickness in the vertical direction DR3 of the second end portion of the first layer 161 that comes into contact with the side wall of the second channel pattern NS2 may be thicker than a thickness in the vertical direction DR3 of a center portion of the first layer 161.

In some embodiments, a portion grown from the side wall of the first channel pattern NS1 in the horizontal direction and the second portion 161_2 may be combined with a portion grown from the side wall of the second channel pattern NS2 in the horizontal direction. The first layer 161 grown from the first channel pattern NS1 and the second channel pattern NS2 in the horizontal direction may include a material that provides a compressive stress to each of the first channel pattern NS1 and the second channel pattern NS2. For example, when the first channel pattern NS1 and the second channel pattern NS2 are silicon patterns, the first layer 161 may include a material (e.g., silicon carbide (SiC)) having a smaller lattice constant than silicon (Si), the first layer 161 grown from the first channel pattern NS1 and the second channel pattern NS2 in the horizontal direction may provide a compressive stress to each of the first channel pattern NS1 and the second channel pattern NS2, and a carrier mobility of the channel region may be improved.

In some other embodiments, as in FIGS. 14 and 15, the first portion 161_1 may grow from the side wall of the first channel pattern NS1 in the horizontal direction, and the second portion 161_2 may grow from the side wall of the second channel pattern NS2 in the horizontal direction. The first portion 161_1 pattern NS1 grown from the first channel pattern NS1 in the horizontal direction may include a material that provides a tensile stress to the first channel pattern NS1. For example, when the first channel pattern NS1 and the second channel pattern NS2 are silicon patterns, the first layer 161 may include a material (e.g., silicon germanium (SiGe)) having a larger lattice constant than silicon (Si), the first portion 161_1 may provide the tensile stress to the first channel pattern NS1, the second portion 161_2 grown from the second channel pattern NS2 in the horizontal direction may provide the tensile stress to the second channel pattern NS2, and the carrier mobility of the channel region may be improved.

The second layer 162 may be formed on or below the first layer 161. The third layer 163 may be formed on or above the first layer 161. For example, the second layer 162 and the third layer 163 may be formed by an epitaxial growth from the first layer 161. The second layer 162 and the third layer 163 may come into contact with the first layer 161.

A position of an uppermost part of the second layer 162 and a position of a lowermost part of the third layer 163 are not limited to those shown and may be varied.

The fourth layer 164 may be formed on or below the second layer 162. The fifth layer 165 may be formed on or above the third layer 163. For example, the fourth layer 164 may be formed by an epitaxial growth from the second layer 162, and the fifth layer 165 may be formed by an epitaxial growth from the third layer 163. The fourth layer 164 may come into contact with the sacrificial spacer 151 and the sacrificial filling film 152. The fourth layer 164 may be formed between the sacrificial spacer 151, the sacrificial filling film 152, and the second layer 162.

Although an upper surface of the fifth layer 165 is shown to be located above a lower surface of the front spacer 140 in the drawings, the embodiment is not limited thereto. The upper surface of the fifth layer 165 may be disposed on the substantially same plane as the lower surface of the front spacer 140.

In the semiconductor device according to some embodiments, the source/drain pattern 160 may grow from the first channel pattern NS1 and the second channel pattern NS2 in the horizontal direction. Because the source/drain pattern 160 does not grow from the sacrificial pattern 150, the sacrificial pattern 150 may not be limited to a semiconductor material (e.g., silicon germanium (SiGe)), and may be formed of various materials such as a dielectric material. Accordingly, a degree of freedom in design (shape, material, etc.) of the sacrificial pattern 150 may be improved. In addition, a material of the first layer 161 of the source/drain pattern 160 may be adjusted to apply a stress to the first channel pattern NS1 and the second channel pattern NS2.

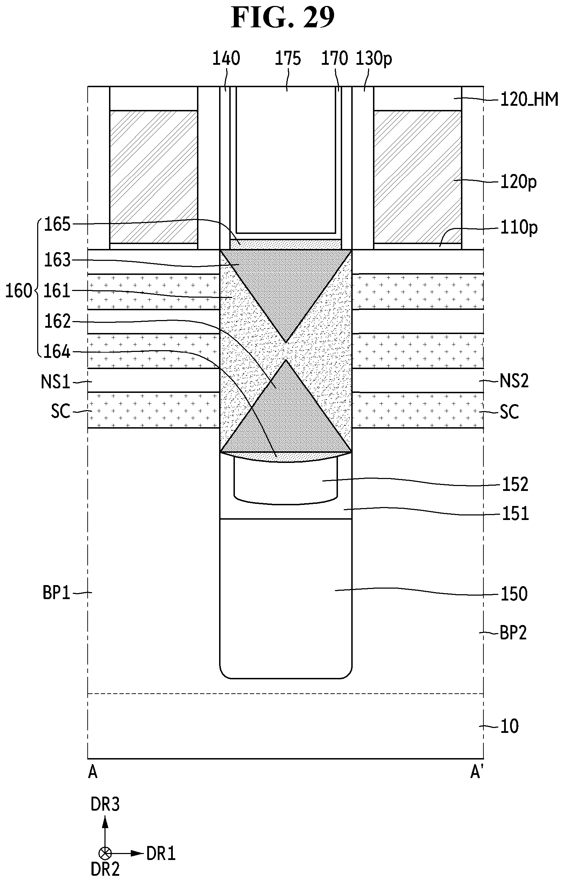

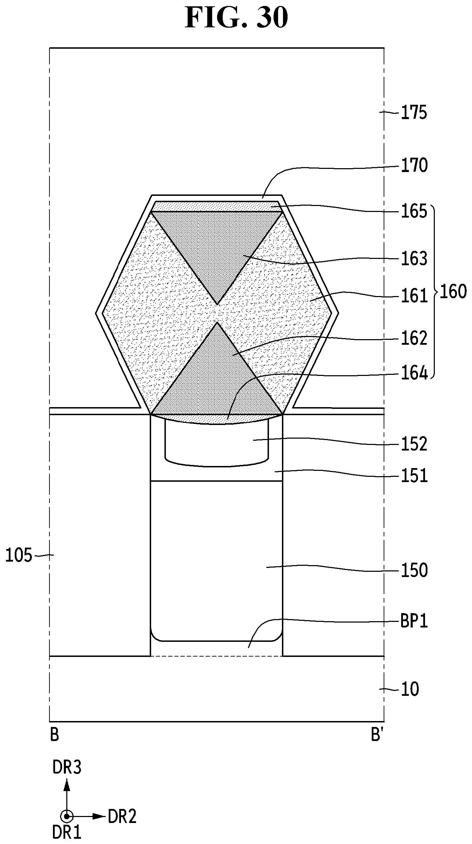

Referring to FIGS. 29 and 30, the source/drain etching stop film 170 and the front interlayer insulating film 175 may be sequentially formed on the source/drain pattern 160.

Referring to FIGS. 29 to 31, a part of the front interlayer insulating film 175, a part of the source/drain etching stop film 170, and the dummy gate capping film 120_HM may be removed to expose the upper surface of the dummy gate electrode 120p. While the upper surface of the dummy gate electrode 120p is exposed, the gate spacer 130 may be formed.

The dummy gate insulating film 110p and the dummy gate electrode 120p may be removed to expose the sacrificial film SC between the gate spacers 130, and the first and second channel patterns NS1 and NS2.

Next, the sacrificial film SC may be removed, and the gate insulating film 110 and the gate electrode 120 may be formed in a space from which the sacrificial film SC is removed. As a result, the gate structure GS and the inner gate structure IGS may be formed. Furthermore, the gate capping pattern 145 may be formed.

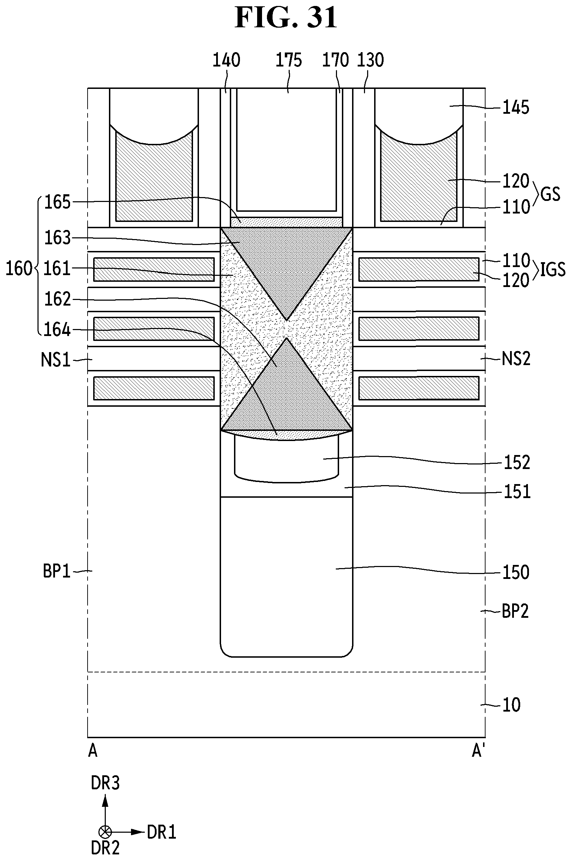

Referring to FIGS. 31 to 33, the substrate 10, the first lower pattern BP1, and the second lower pattern BP2 may be removed. Accordingly, the field insulating film 105 and the sacrificial pattern 150 may be exposed.

In some embodiments, in a process of removing the substrate 10, the first lower pattern BP1, and the second lower pattern BP2, a part of the first lower pattern BP1 and/or a part of the second lower pattern BP2 may remain. The remaining part of the first lower pattern BP1 and/or the remaining part of the second lower pattern BP2 may become the substrate pattern 100.

In some embodiments, the substrate 10, the first lower pattern BP1, and the second lower pattern BP2 may all be removed. In this case, the substrate pattern 100 may not be formed.

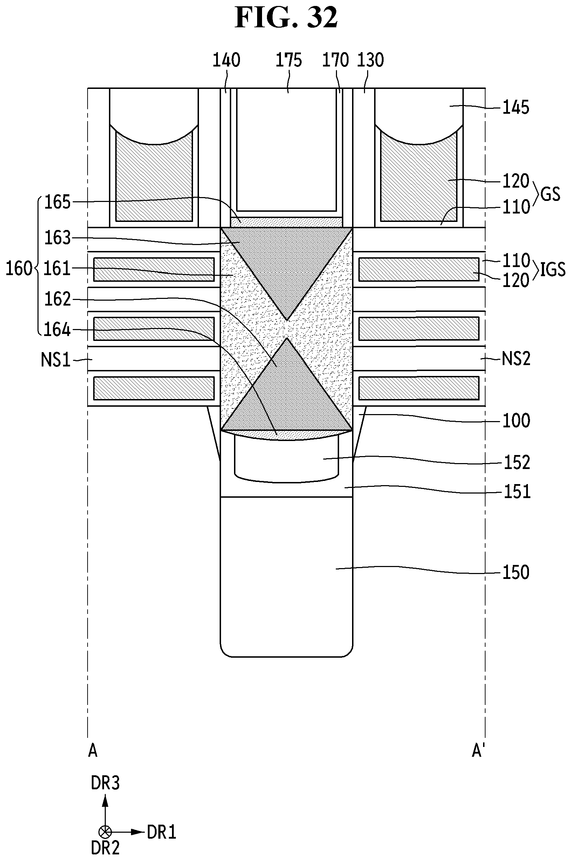

Referring to FIGS. 32 to 35, a pre-back interlayer insulating film 180p which fills a space from which the substrate 10, the first lower pattern BP1, and the second lower pattern BP2 are removed may be formed. The pre-back interlayer insulating film 180p may cover the sacrificial pattern 150, the sacrificial spacer 151, the substrate pattern 100, the field insulating film 105, and a lowermost surface of the inner gate structure IGS.

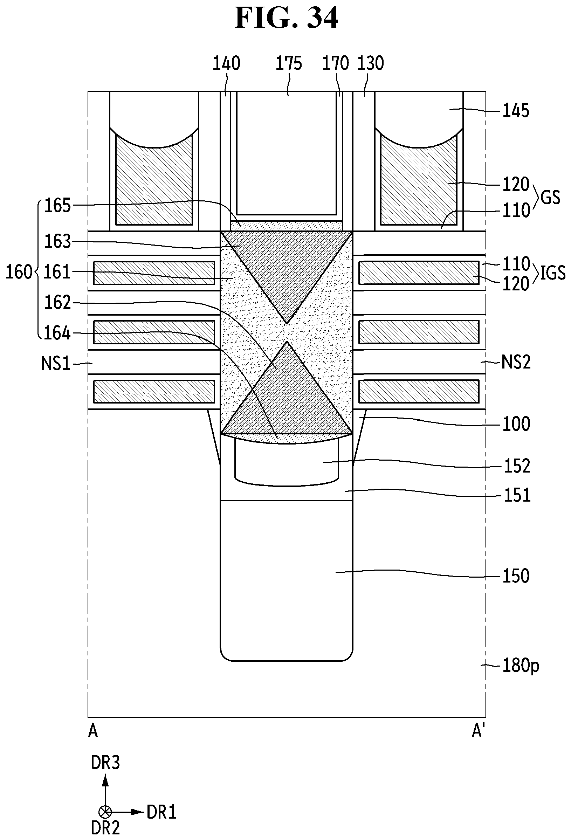

Referring to FIGS. 34 to 37, a part of the back interlayer insulating film 180p may be etched to expose the sacrificial pattern 150, thereby forming the back interlayer insulating film 180. For example, a planarization process may be performed on the pre-back interlayer insulating film 180p until the sacrificial pattern 150 is exposed.

Next, the sacrificial pattern 150 may be removed to form a third hole H3. The third hole H3 may be defined by the back interlayer insulating film 180 and the sacrificial spacer 151. Only the sacrificial pattern 150 of a position at which the back source/drain contact 195 is formed later may be removed. That is, the sacrificial pattern 150 of a position, at which the back source/drain contact 195 is not formed, may remain without being removed.

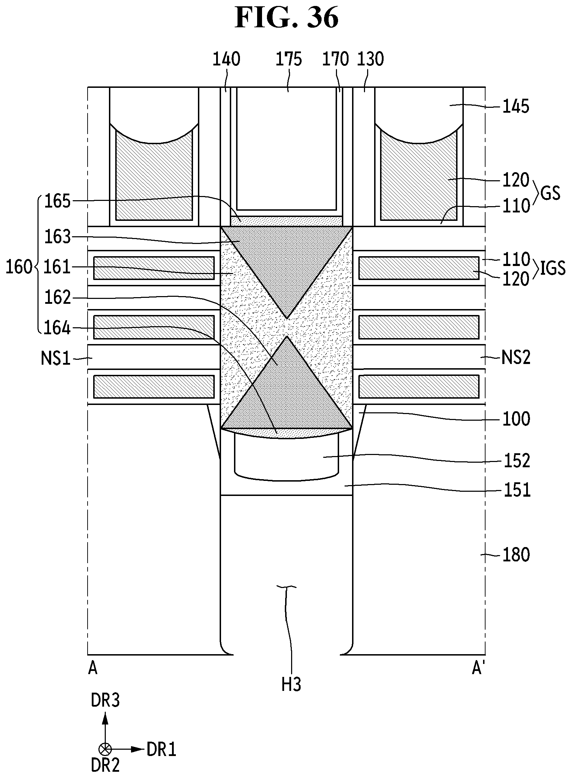

Referring to FIGS. 36 to 39, the sacrificial spacer 151 and the sacrificial filling film 152 may be removed through the third hole H3 to form a fourth hole H4. The fourth hole H4 may be defined by the back interlayer insulating film 180 and the source/drain pattern 160. The source/drain pattern 160 may be exposed by the fourth hole H4. A wet cleaning process may be performed in a process of removing the sacrificial spacer 151 and the sacrificial filling film 152.

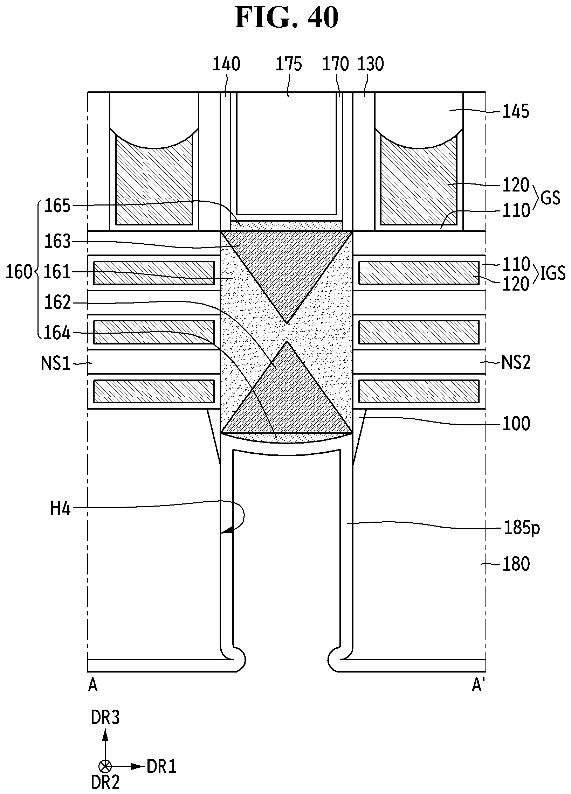

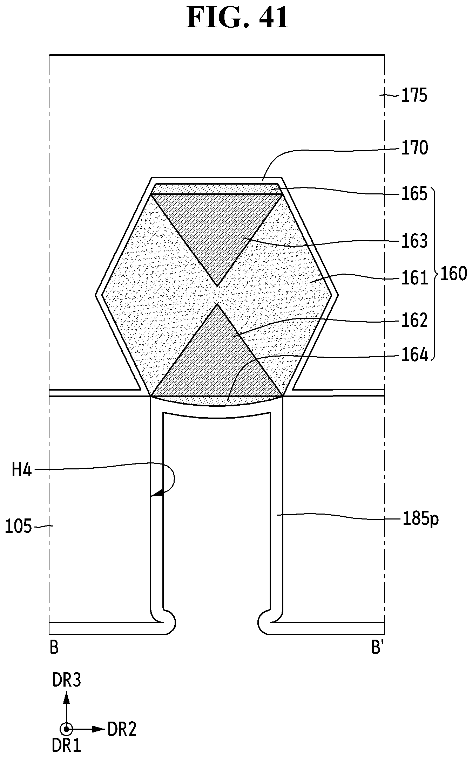

Referring to FIGS. 40 and 41, a pre-back spacer 185p may be formed along the fourth hole H4 and the back interlayer insulating film 180. The pre-back spacer 185p may be formed along a profile of the fourth hole H4 and a profile of a lower surface of the back interlayer insulating film 180.

Referring to FIGS. 40 to 43, a fifth hole H5 that penetrates a part of the source/drain pattern 160 may be formed. The fifth hole H5 may penetrate a part of the fourth layer 164 and the second layer 162 of the source/drain pattern 160. The fifth hole H5 may expose the source/drain pattern 160.

The pre-back spacer 185p on the lower surface of the back interlayer insulating film 180 and the lower surface of the source/drain pattern 160 may be removed. Accordingly, the back spacer 185 may be formed.

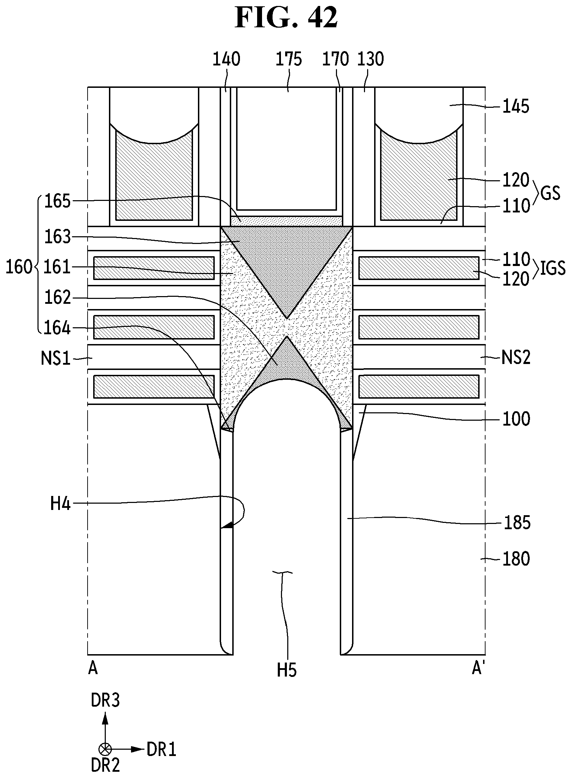

Next, referring to FIGS. 42, 43, 2 and 3, the back contact silicide film 190 and the back source/drain contact 195 may be formed in the fifth hole H5.

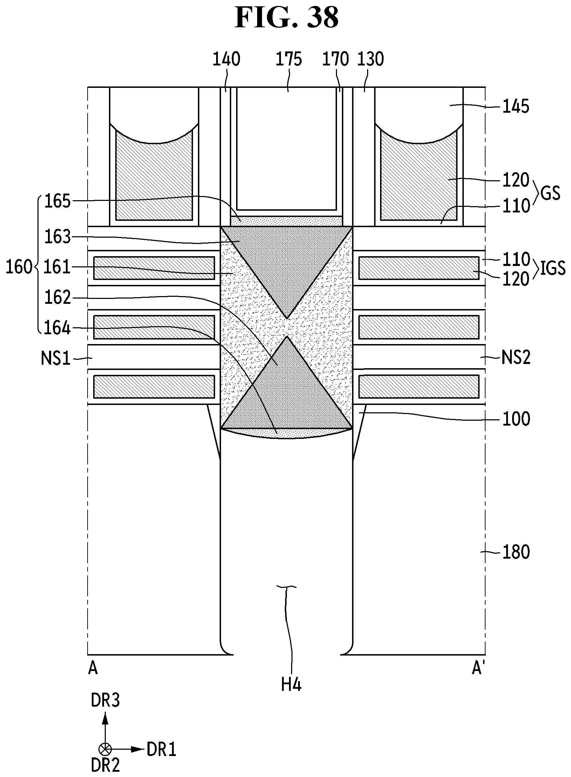

Referring to FIGS. 6 and 7, in some embodiments, a hole for exposing the source/drain pattern 160 may be formed immediately after a fabrication process of FIGS. 38 and 29 is performed. A process of forming the pre-back spacer 185p and the back spacer 185 may be omitted. Next, the back contact silicide film 190 and the back source/drain contact 195 may be formed in the hole.

Although the example embodiments of the present disclosure have been described above with reference to the accompanying drawings, the present disclosure is not limited to the above embodiments, and may be fabricated in various different forms. Those skilled in the art will appreciate that the present disclosure may be embodied in other specific forms without changing the technical spirit or essential features of the present disclosure. Accordingly, the above-described embodiments should be understood in all respects as illustrative and not restrictive.

## Claims

1. A semiconductor device comprising:
a back interlayer insulating film (180);
a plurality of first channel patterns (NS1; BNS1) on the back interlayer insulating film (180) and spaced apart from each other in a vertical direction (DR3);
a plurality of second channel patterns (NS2; BNS2) on the back interlayer insulating film (180) and spaced apart from each other in the vertical direction (DR3), and are spaced apart from the plurality of first channel patterns (NS1; BNS1) in a first horizontal direction (DR1);
a source/drain pattern (160; 160B) between the plurality of first channel patterns (NS1; BNS1) and the plurality of second channel patterns (NS2; BNS2); and
at least one source/drain contact (195, 295) connected to the source/drain pattern (160; 160B),
wherein the source/drain pattern (160; 160B) comprises:
a first layer (161; 161B) which comes into contact with the plurality of first channel patterns (NS1; BNS1) and the plurality of second channel patterns (NS2; BNS2),
a second layer (162; 162B) on or below the first layer (161; 161B), and
a third layer (163; 163B) on or above the second layer (162; 162B),
wherein a width of the first layer (161; 161B) in the vertical direction (DR3) decreases and then increases, along a direction from the plurality of first channel patterns (NS1; BNS1) to the plurality of second channel patterns (NS2; BNS2).

2. The semiconductor device of claim 1, further comprising:
a front interlayer insulating film (175) on the plurality of first channel patterns (NS1) and the plurality of second channel patterns (NS2),
wherein the at least one source/drain contact (195, 295) comprises a front source/drain contact (295) that penetrates the front interlayer insulating film (175) and comes into contact with the third layer (163) of the source/drain pattern (160).

3. The semiconductor device of claim 2, further comprising:
a sacrificial pattern (150) in the back interlayer insulating film (180) below the source/drain pattern (160).

4. The semiconductor device of claim 3, further comprising:
a sacrificial spacer (151) that defines a trench, and a sacrificial filling film (152) that fills the trench, between the source/drain pattern (160) and the sacrificial pattern (150).

5. The semiconductor device of claim 3 or 4, wherein the sacrificial pattern (150) comprises a dielectric pattern or a semiconductor material.

6. The semiconductor device of any one of claims 2 to 5, further comprising:
a front spacer (140) between the front interlayer insulating film (175) and the front source/drain contact (295).

7. The semiconductor device of any one of claims 1 to 6, wherein the at least one source/drain contact (195, 295) comprises a back source/drain contact (195) that penetrates the back interlayer insulating film (180), and comes into contact with the second layer (162) of the source/drain pattern (160).

8. The semiconductor device of claim 7, further comprising:
a back spacer (185) between the back interlayer insulating film (180) and the back source/drain contact (195).

9. The semiconductor device of claim 7 or 8, further comprising:
a substrate pattern (100) between the back interlayer insulating film (180) and the back source/drain contact (195).

10. The semiconductor device of any one of claims 1 to 9, wherein the second layer (162) and third layer (163) comprise a same material.

11. A semiconductor device comprising:
a back interlayer insulating film (180);
a plurality of first channel patterns (NS1) on the back interlayer insulating film (180) and spaced apart from each other in a vertical direction (DR3);
a plurality of second channel patterns (NS2) on the back interlayer insulating film (180), spaced apart from each other in the vertical direction (DR3), and spaced apart from the plurality of first channel patterns (NS1) in a first horizontal direction (DR1);
a source/drain pattern (160) between the plurality of first channel patterns (NS1) and the plurality of second channel patterns (NS2); and
a source/drain contact connected to the source/drain pattern (160),
wherein the source/drain pattern (160) comprises:
a first layer (161) which comes into contact with the plurality of first channel patterns (NS1) and the plurality of second channel patterns (NS2),
a second layer (162) on or below the first layer (161), and
a third layer (163) on or above the first layer (161), and comprising a same material as the second layer (162).

12. The semiconductor device of any one of claims 1 to 11, wherein each of the first layer (161), the second layer (162), and the third layer (163) comprises a dopant, and
wherein a first concentration of the dopant in the first layer (161) is smaller than a second concentration of the dopant in the second layer (162) and smaller than a third concentration of the dopant in the third layer (163).

13. A semiconductor device comprising:
a first lower channel pattern (BNS1) and a second lower channel pattern (BNS2) which are spaced apart from each other in a first horizontal direction (DR1);
a first upper channel pattern (UNS1) spaced apart from the first lower channel pattern (BNS1) in a vertical direction (DR3);
a second upper channel pattern (UNS2) spaced apart from the second lower channel pattern (BNS2) in the vertical direction (DR3);
a lower source/drain pattern (160B) which comes into contact with the first lower channel pattern (BNS1) and the second lower channel pattern (BNS2); and
an upper source/drain pattern (160U) which comes into contact with the first upper channel pattern (UNS1) and the second upper channel pattern (UNS2),
wherein the lower source/drain pattern (160B) comprises a first lower layer (161B) which comes into contact with the first lower channel pattern (BNS1) and the second lower channel pattern (BNSs), a second lower layer (162B) on or below the first lower layer (161B), and a third lower layer (163B) on or above the first lower layer (161B), and
wherein the upper source/drain pattern (160U) comprises a first upper layer (161U) which comes into contact with the first upper channel pattern and the second upper channel pattern (UNS2), a second upper layer on or below the first upper layer (161U), and a third upper layer on or above the first upper layer (161U).

14. The semiconductor device of claim 13, wherein the second lower layer (162B) and the third lower layer (163B) are spaced apart from each other by the first lower layer (161B),
wherein the first upper layer (161U) comprises a first portion that comes into contact with the first upper channel pattern (UNS1), and a second portion that comes into contact with the second upper channel pattern (UNS2),
wherein the first portion and the second portion are spaced apart from each other, and
wherein the second upper layer (162U) and the third upper layer (163U) are connected to each other.

15. The semiconductor device of claim 13 or 14, further comprising:
a back source/drain contact (195) which comes into contact with the second lower layer (162B) of the lower source/drain pattern (160B); and
a front source/drain contact (295) which comes into contact with the third upper layer (163U) of the upper source/drain pattern (160U).
